# EUROPEAN PATENT APPLICATION

(11) **EP 4 293 842 A1**
(43) Date of publication of application: **20.12.2023**
(21) Application number: 22752496.4
(22) Date of filing: 11.01.2022
(51) Int. Cl.: H01S 5/183, H01S 5/343

(54) **VERTICAL CAVITY SURFACE EMITTING LASER ELEMENT**

(30) Priority: 10.02.2021 JP 2021020112
(71) Applicant: Sony Group Corporation, Tokyo 108-0075 (JP)
(72) Inventor: HAMAGUCHI, Tatsushi, Tokyo 108-0075 (JP); NAKAYAMA, Eiji, Kikuchi-gun, Kumamoto 869-1102 (JP); HAYASHI, Kentaro, Tokyo 108-0075 (JP); YOKOZEKI, Mikihiro, Tokyo 108-0075 (JP); KODA, Rintaro, Tokyo 108-0075 (JP)
(74) Representative: D Young & Co LLP
(86) International application number: PCT/JP2022/000508
(87) International publication number: WO 2022/172663

(57) **Abstract**

[Object] To provide a vertical cavity surface emitting laser device having a concave mirror structure and excellent polarization controllability.

[Solving Means] A vertical cavity surface emitting laser device according to the present technology includes: a first light-reflecting layer; a second light-reflecting layer; and a stacked body. The stacked body includes a first semiconductor layer, a second semiconductor layer, and an active layer, and is disposed between the first light-reflecting layer and the second light-reflecting layer. The stacked body has a current confinement structure for confining a current and forming a current injection region where a current concentrates. The first light-reflecting layer includes a concave mirror having a concave surface on a side of the stacked body and a convex surface on a side opposite to the stacked body. A first figure and a second figure are not similar, the first figure being a plane figure of the current injection region when viewed from an optical axis direction of emitted light, the second figure being a plane figure of a contour line when viewed from the optical axis direction, the contour line representing a height of the concave mirror from the active layer.

## Description

### Technical Field

The present technology relates to a vertical cavity surface emitting laser device that emits laser light in a direction perpendicular to a layer surface.

### Background Art

A VCSEL (Vertical Cavity Surface Emitting Laser) device has a structure in which a light-emitting layer is sandwiched between a pair of reflection mirrors. A current confinement structure is provided in the vicinity of the light-emitting layer, and a current concentrates in a partial region (hereinafter, a current injection region) in the light-emitting layer by the current confinement structure to generate spontaneous emission light. The pair of reflection mirrors forms a resonator and reflects light of a predetermined wavelength, of the spontaneous emission light, toward the light-emitting layer, thereby causing laser oscillation.

In recent years, a VCSEL device in which one of reflection mirrors is a concave mirror has been reported (see Non-Patent Literature 1). In this structure, an optical field confined in the lateral direction (layer surface direction) is formed in the current injection region and the size of the optical field can be controlled by the length of the resonator and the radius of curvature of the concave mirror (see Non-Patent Literatures 2 and 3).

### Citation List

### Non-Patent Literature

Non-Patent Literature 1: T. Hamaguchi et al., Sci. Rep., vol. 8, no. 1, pp. 1?10, 2018.
Non-Patent Literature 2: T. Hamaguchi et al 2019 Appl. Phys. Express 12 044004
Non-Patent Literature 3: T. Hamaguchi et al 2019 Japanese Journal of Applied Physics 58, SC0806 (2019)
Non-Patent Literature 4: T. Hamaguchi et al, Applied Physics Express 13, 041002 (2020)
Non-Patent Literature 5: C.L. Chua et al, "Anisotropic apertures for polarization-stable laterally oxidized vertical-cavity lasers" Appl. Phys. Lett. 73,1631(1998)
Non-Patent Literature 6: M.Ortsiefer et al,"Submilliamp long-wavelength InP-based vertical-cavity surface-emitting laser with stable linear polarisation" ELECTRONICS LETTERS 22nd June 2000 Vol. 36 No. 13

### Disclosure of Invention

### Technical Problem

Here, a semiconductor laser device such as a VCSEL device is generally used by providing an external optical system and shaping and adjusting emitted light. At this time, many of the external optical parts to be used exhibit an effect in a specific polarization direction. Therefore, the semiconductor laser device is desired to have a specific polarization direction.

Several methods are conceivable for controlling the polarization direction of a VCSEL device, but it is essential to provide some asymmetry. For example, it is conceivable to give anisotropy to various parameters such as the structure (refractive index distribution) of a cavity (between a pair of reflection mirrors), gain, and loss (including reflectance). However, each method has strengths and weaknesses in the polarization selectivity, and in general, a method of achieving stronger polarization control by combining a plurality of polarization control methods is often adopted.

One of the polarization control methods is the plane orientation of crystals forming a VCSEL device. If there is asymmetry in the crystals when viewed from the direction of light emission, spatial asymmetry is produced in the gain, and thus, asymmetry, specific polarization in this case, is produced also in the emitted light. For example, in the case of a nitride VCSEL (GaN-VCSEL) device, the use of m-plane or 20-21-plane tends to polarize light in a specific direction (see Non-Patent Literature 4).

However, the C-plane often used to produce a VCSEL device lacks asymmetry, and emitted light cannot achieve specific polarization and is random in accordance with the VCSEL device. The polarization can also be controlled by using a plane close to the C-plane (plane slightly inclined within several degrees from the C-plane). However, in the case where the C-plane is offset only as compared to the case of using a semipolar plane, the polarization selectivity is weak and an increase in the offset angle has a specific problem such as causing undulations called bunching on the substrate surface during crystal growth. This point is a problem when using the C-plane. Few reports have been made on controlling the polarization in a specific direction in a GaN-VCSEL device using the C-plane.

Examples of another polarization control method includes a stress. Applying a stress to a VCSEL device distorts the crystals and splits the band, making it possible to achieve polarization in a specific direction. As still another polarization control method, there is a method of making the cavity structure when viewed from the optical axis direction asymmetric to control the polarization in a specific direction corresponding to the asymmetry. In particular, there is an example in which polarization control is performed by making the confinement structure in the lateral direction asymmetric. For example, in the case where GaAs is used, a confinement structure in the lateral direction is achieved by oxidizing a layer containing a high-concentration of Al in the lateral direction, and an attempt to control the polarization by making the plane figure thereof have a structure other than a perfect circle is known (see Non-Patent Literatures 5 and 6).

The existing method described above realizes the lateral confinement of a current and an optical field with a single component and is established by making the single component asymmetric. Meanwhile, in the concave mirror structure that has been studies in recent years, there is a unique situation in which a current and an optical field are controlled by separate structures. Therefore, a method of making the lateral confinement of both light and a current asymmetric by devising a single component is not necessarily established unlike the past, and there has been a need to provide the lateral asymmetry of light and a current by a more complect method.

In view of the circumstances as described above, it is an object of the present technology to provide a vertical cavity surface emitting laser device having a concave mirror structure and excellent polarization controllability.

### Solution to Problem

In order to achieve the above-mentioned object, a vertical cavity surface emitting laser device according to the present technology includes: a first light-reflecting layer; a second light-reflecting layer; and a stacked body.

The first light-reflecting layer reflects light of a specific wavelength.

The second light-reflecting layer reflects light of the wavelength.

The stacked body includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination.

The stacked body has a current confinement structure for confining a current and forming a current injection region where a current concentrates.

The first light-reflecting layer includes a concave mirror having a concave surface on a side of the stacked body and a convex surface on a side opposite to the stacked body.

A first figure and a second figure are not similar, the first figure being a plane figure of the current injection region when viewed from an optical axis direction of emitted light, the second figure being a plane figure of a contour line when viewed from the optical axis direction, the contour line representing a height of the concave mirror from the active layer.

In order to achieve the above-mentioned object, a vertical cavity surface emitting laser device according to the present technology includes: a first light-reflecting layer; a second light-reflecting layer; and a stacked body.

The first light-reflecting layer reflects light of a specific wavelength.

The second light-reflecting layer reflects light of the wavelength.

The stacked body includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination.

The stacked body has a current confinement structure for confining a current and forming a current injection region where a current concentrates.

The first light-reflecting layer includes a concave mirror having a concave surface on a side of the stacked body and a convex surface on a side opposite to the stacked body.

A center of gravity of a first figure and a center of gravity of a second figure do not match, the first figure being a plane figure of the current injection region when viewed from an optical axis direction of emitted light, the second figure being a plane figure of a contour line when viewed from the optical axis direction, the contour line representing a height of the concave mirror from the active layer.

In order to achieve the above-mentioned object, a vertical cavity surface emitting laser device according to the present technology includes: a first light-reflecting layer; a second light-reflecting layer; and a stacked body.

The first light-reflecting layer reflects light of a specific wavelength.

The second light-reflecting layer reflects light of the wavelength.

The stacked body includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination.

The stacked body has a current confinement structure for confining a current and forming a current injection region where a current concentrates.

The first light-reflecting layer includes a concave mirror having a concave surface on a side of the stacked body and a convex surface on a side opposite to the stacked body.

Both a first figure and a second figure are not perfect circles but similar, the first figure being a plane figure of the current injection region when viewed from an optical axis direction of emitted light, the second figure being a plane figure of a contour line when viewed from the optical axis direction, the contour line representing a height of the concave mirror from the active layer.

The first figure may be a closed figure including a circle, an ellipse, a rectangle, or a combination of at least two of them, and
the second figure may be a closed figure including a circle, an ellipse, a rectangle, or a combination of at least two of them and be a figure dissimilar to the first figure.

A distance between the center of gravity of the first figure and the center of gravity of the second figure in a plane perpendicular to the optical axis direction may be 0.03 um or more.

The first figure may be a closed figure including a circle, an ellipse, a rectangle, or a combination of at least two of them, and
the second figure may be a closed figure including a circle, an ellipse, a rectangle, or a combination of at least two of them and be a figure similar to the first figure.

The center of gravity of the first figure and the center of gravity of the second figure may match.

The current confinement structure may have a non-ion-implantation region in which ions are not implanted into the stacked body and an ion implantation region that is provided around the non-ion-implantation region, ions being implanted into the stacked body in the ion implantation region, the current injection region being the non-ion-implantation region.

The first semiconductor layer and the second semiconductor layer may be formed of GaN.

The first semiconductor layer may include a C-plane GaN substrate.

The ions may be boron ions.

The current confinement structure may have a tunnel junction region in which a tunnel junction is formed in the stacked body and a non-tunnel-junction region that is provided around the tunnel junction region, no tunnel junction being formed in the non-tunnel-junction region, and
the current injection region may be the tunnel junction region.

The tunnel junction region may be formed by a buried tunnel junction.

The tunnel junction region may be formed by a tunnel junction layer into which ions are not implanted, and
the non-tunnel-junction region may be formed by a tunnel junction layer into which ions are implanted.

The first semiconductor layer and the second semiconductor layer may be formed of InP.

The current confinement structure may have a non-oxidized region in which a semiconductor material is not oxidized in the stacked body and an oxidized region that is provided around the non-oxidized region, a semiconductor material being oxidized in the oxidized region,
the current injection region may be the non-oxidized region.

The first semiconductor layer and the second semiconductor layer may be formed of GaAs.

The first semiconductor layer may have a first surface on a side of the active layer and a second surface on a side opposite to the active layer, a base that forms a convex curved surface being provided on the second surface, and
the first light-reflecting layer may be a multilayer light-reflecting film provided on the second surface, a portion of the first light-reflecting layer that is a multilayer light-reflecting film forming and provided on the base forming the concave mirror.

The vertical cavity surface emitting laser device may further include a substrate that has a first surface on a side of the active layer and a second surface on a side opposite to the active layer, a base that forms a convex curved surface being provided on the second surface,
the first light-reflecting layer being a multilayer light-reflecting film provided on the second surface, a portion of the first light-reflecting layer that is a multilayer light-reflecting film and provided on the base forming the concave mirror.

The concave mirror may have a concave surface on a side of the active layer, and the concave surface has a radius of curvature of 1000 um or less.

### Brief Description of Drawings

[Fig. 1] Fig. 1 is a cross-sectional view of a VCSEL device according to a first embodiment of the present technology.
[Fig. 2] Fig. 2 is an exploded cross-sectional view of a partial configuration of the VCSEL device.
[Fig. 3] Fig. 3 is a schematic diagram showing a current injection region and an insulation region of the VCSEL device.
[Fig. 4] Fig. 4 is a schematic diagram showing a positional relationship between the current injection region and a concave mirror of the VCSEL device.
[Fig. 5] Fig. 5 is a schematic diagram showing an operation of the VCSEL device.
[Fig. 6] Fig. 6 is a schematic diagram showing contour lines of the concave mirror included in the VCSEL device.
[Fig. 7] Fig. 7 is a schematic diagram showing a plane figure of the contour line of the concave mirror included in the VCSEL device.
[Fig. 8] Fig. 8 is a schematic diagram showing a plane figure of the current injection region of the VCSEL device.
[Fig. 9] Fig. 9 is a schematic diagram showing a relationship between the plane figures of the contour line of the concave mirror included in the VCSEL device and the current injection region.
[Fig. 10] Fig. 10 is a schematic diagram showing a relationship between the plane figures of the contour line of the concave mirror included in the VCSEL device and the current injection region.
[Fig. 11] Fig. 11 is a schematic diagram showing a relationship between the plane figures of the contour line of the concave mirror included in the VCSEL device and the current injection region.
[Fig. 12] Fig. 12 is a schematic diagram showing a relationship between the plane figures of the contour line of the concave mirror included in the VCSEL device and the current injection region.
[Fig. 13] Fig. 13 is a schematic diagram showing a relationship between the plane figures of the contour line of the concave mirror included in the VCSEL device and the current injection region.
[Fig. 14] Fig. 14 is a schematic diagram showing a relationship between the plane figures of the contour line of the concave mirror included in the VCSEL device and the current injection region.
[Fig. 15] Fig. 15 is a schematic diagram showing a relationship between the plane figures of the contour line of the concave mirror included in the VCSEL device and the current injection region.
[Fig. 16] Fig. 16 is a schematic diagram showing a relationship between the plane figures of the contour line of the concave mirror included in the VCSEL device and the current injection region.
[Fig. 17] Fig. 17 is a schematic diagram showing a relationship between the plane figures of the contour line of the concave mirror included in the VCSEL device and the current injection region.
[Fig. 18] Fig. 18 is a schematic diagram showing a relationship between the plane figures of the contour line of the concave mirror included in the VCSEL device and the current injection region.
[Fig. 19] Fig. 19 is a schematic diagram showing a relationship between the plane figures of the contour line of the concave mirror included in the VCSEL device and the current injection region.
[Fig. 20] Fig. 20 is a schematic diagram showing a relationship between the plane figures of the contour line of the concave mirror included in the VCSEL device and the current injection region.
[Fig. 21] Fig. 21 is a schematic diagram showing a relationship between the plane figures of the contour line of the concave mirror included in the VCSEL device and the current injection region.
[Fig. 22] Fig. 22 is a schematic diagram showing a relationship between the plane figures of the contour line of the concave mirror included in the VCSEL device and the current injection region.
[Fig. 23] Fig. 23 is a schematic diagram showing a relationship between the plane figures of the contour line of the concave mirror included in the VCSEL device and the current injection region.
[Fig. 24] Fig. 24 is a schematic diagram showing a method of producing the VCSEL device.
[Fig. 25] Fig. 25 is a schematic diagram showing a method of producing the VCSEL device.
[Fig. 26] Fig. 26 is a schematic diagram showing a method of producing the VCSEL device.
[Fig. 27] Fig. 27 is a cross-sectional view of a VCSEL device according to a second embodiment of the present technology.
[Fig. 28] Fig. 28 is a schematic diagram showing a current injection region and an insulation region of the VCSEL device.
[Fig. 29] Fig. 29 is a schematic diagram showing a positional relationship between the current injection region and a concave mirror of the VCSEL device.
[Fig. 30] Fig. 30 is a schematic diagram showing contour lines of the concave mirror included in the VCSEL device.
[Fig. 31] Fig. 31 is a cross-sectional view of a VCSEL device according to the second embodiment of the present technology, which has another configuration.
[Fig. 32] Fig. 32 is a schematic diagram showing a positional relationship between a current injection region and a concave mirror of the VCSEL device.
[Fig. 33] Fig. 33 is a cross-sectional view of a VCSEL device according to a third embodiment of the present technology.
[Fig. 34] Fig. 34 is a schematic diagram showing a current injection region and an insulation region of the VCSEL device.
[Fig. 35] Fig. 35 is a schematic diagram showing a positional relationship between the current injection region and a concave mirror of the VCSEL device.
[Fig. 36] Fig. 36 is a schematic diagram showing contour lines of the concave mirror included in the VCSEL device.

### Mode(s) for Carrying Out the Invention

### (First embodiment)

A VCSEL (Vertical Cavity Surface Emitting Laser) device according to a first embodiment of the present technology will be described. In the drawings of the present disclosure, the optical axis direction of light emitted from the VCSEL device is defined as a Z direction, a direction orthogonal to the Z direction is defined as an X direction, and a direction orthogonal to the Z direction and the X direction is defined as a Y direction.

### [Structure of VCSEL device]

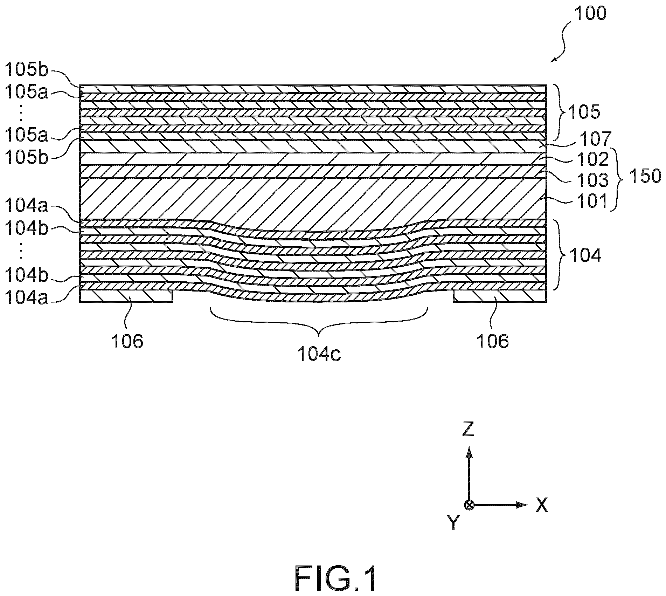

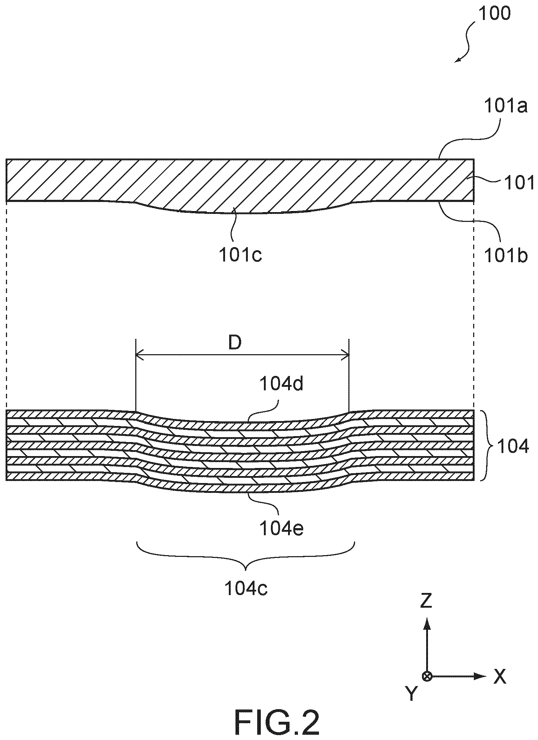

Fig. 1 is a cross-sectional view of a VCSEL device 100 according to this embodiment, and Fig. 2 is a schematic diagram showing an exploded partial configuration of the VCSEL device 100. As shown in these figures, the VCSEL device 100 includes a first semiconductor layer 101, a second semiconductor layer 102, an active layer 103, a first light-reflecting layer 104, a second light-reflecting layer 105, a first electrode 106, and a second electrode 107. Of these, the first semiconductor layer 101, the second semiconductor layer 102, and the active layer 103 are collectively referred to as a stacked body 150.

Each of these layers has a layer surface direction along the X-Y plane, and the first electrode 106, the first light-reflecting layer 104, the first semiconductor layer 101, the active layer 103, the second semiconductor layer 102, the second electrode 107, and the second light-reflecting layer 105 are stacked in this order. Therefore, the stacked body 150 is disposed between the first light-reflecting layer 104 and the second light-reflecting layer 105.

The first semiconductor layer 101 is a layer that is formed of a semiconductor having a first conductivity type and transports carriers to the active layer 103. The first conductivity type can be an n-type, and the first semiconductor layer 101 can include, for example, a C-plane n-GaNa substrate. Fig. 2 is a diagram showing the first semiconductor layer 101 and the first light-reflecting layer 104 separately from each other. As shown in the figure, the first semiconductor layer 101 has a first surface 101a on the side of the active layer 103 and a second surface 101b on the side opposite to the active layer 103.

A base 101c is provided on the side of the second surface 101b of the first semiconductor layer 101. The base 101c is a portion of the second surface 101b that protrudes in a convex curved surface shape and has, for example, a spherical lens shape. Further, the shape of the base 101c is not limited to the spherical lens shape as long as the second surface 101b is a convex curved surface.

The second semiconductor layer 102 is a layer that is formed of a semiconductor having a second conductivity type and transports carriers to the active layer 103. The second conductivity type can be a p-type, and the second semiconductor layer 102 can be formed of, for example, p-GaN.

The active layer 103 is a layer that is disposed between the first semiconductor layer 101 and the second semiconductor layer 102 and emits light by carrier recombination. The active layer 103 has a multiple quantum well structure in which a quantum well layer and a barrier layer are alternately stacked to obtain a plurality of layers, the quantum well layer can be formed of, for example, In_{0.16}Ga_{0.84}N, and the barrier layer can be formed of, for example, In_{0.04}Ga_{0.96}N. Further, the active layer 103 only needs to be a layer that emits light by carrier recombination instead of the multiple quantum well structure.

The first light-reflecting layer 104 reflects light of a specific wavelength (hereinafter, a wavelength λ) and causes light of a wavelength other than that to be transmitted therethrough. The wavelength λ is, for example, 445 nm. As shown in Fig. 1, the first light-reflecting layer 104 can be a DBR (Distributed Bragg Reflector) including a multilayer light-reflecting film in which a high-refractive index layer 104a and a low-refractive index layer 104b having an optical film thickness of λ/4 are alternately stacked to obtain a plurality of layers. The first light-reflecting layer 104 may be a semiconductor DBR formed of a semiconductor material, or may be a dielectric DBR formed of a dielectric material.

The first light-reflecting layer 104 includes a concave mirror 104c. The first light-reflecting layer 104 is stacked on the second surface 101b of the first semiconductor layer 101 to have a certain thickness. As shown in Fig. 2, the surface of the first light-reflecting layer 104 on the side of the stacked body 150 forms a concave surface 104d in accordance with the shape of the base 101c provided on the second surface 101b, and the surface opposite to the stacked body 150 forms a convex surface 104e. As a result, the first light-reflecting layer 104 forms the concave mirror 104c. It is suitable that the diameter D (see Fig. 2) of the concave mirror 104c is 2000 um or less, the radius of curvature (ROC) of the concave surface 104d is 1000 um or less, and the surface accuracy (RMS: Root Mean Square) is 1.0 nm or less. The radius of curvature of the concave surface 104d is more suitably 100 um or less.

The second light-reflecting layer 105 reflects light of the wavelength λ and causes light of a wavelength other than that to be transmitted therethrough. As shown in Fig. 1, the second light-reflecting layer 105 can be a DBR (Distributed Bragg Reflector) including a multilayer light-reflecting film in which a high-refractive index layer 105a and a low-refractive index layer 105b having an optical film thickness of λ/4 are alternately stacked to obtain a plurality of layers. The second light-reflecting layer 105 may be a semiconductor DBR formed of a semiconductor material, or may be a dielectric DBR formed of a dielectric material.

The first electrode 106 is provided around the concave mirror 104c on the first light-reflecting layer 104 and functions as one electrode of the VCSEL device 100. The first electrode 106 can include, for example, a single-layer metal film formed of Au, Ni, Ti, or the like, or a multiplayer metal film formed of Ti/Au, Ag/Pd, Ni/Au/Pt, or the like.

The second electrode 107 is disposed between the second semiconductor layer 102 and the second light-reflecting layer 105 and functions as the other electrode of the VCSEL device 100. The second electrode 107 can be formed of a transparent conductive material such as ITO (Indium Tin Oxide), IZO (Indium Zinc Oxide), and AlMgZnO.

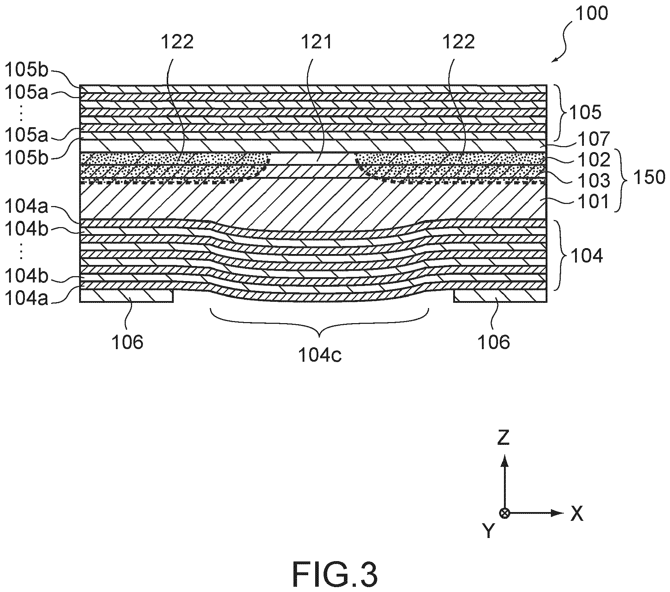

In the VCSEL device 100, a current confinement structure is formed in the stacked body 150. Fig. 3 is a schematic diagram showing the current confinement structure. As shown in the figure, the current confinement structure has a current injection region 121 and an insulation region 122 (dotted region). The current injection region 121 is a region into which ions are not implanted (non-ion-implantation region) and is a region having conductivity. The insulation region 122 is a region surrounding the current injection region 121 in the layer surface direction (X-Y direction) and is a region (ion implantation region) that is insulated by implanting ions into the semiconductor material forming the stacked body 150. The ions to be implanted into the insulation region 122 can be B (boron) ions. Further, ions capable of insulating the semiconductor material, such as O (oxygen) ions and H (hydrogen) ions, may be used instead of the B ions.

A current flowing through the VCSEL device 100 cannot pass through the insulation region 122 and concentrates in the current injection region 121. That is, a current confinement structure is formed by the current injection region 121 and the insulation region 122. Note that the insulation region 122 does not need to be provided in all of the first semiconductor layer 101, the active layer 103, and the second semiconductor layer 102 and only needs to be provided in at least one of these layers.

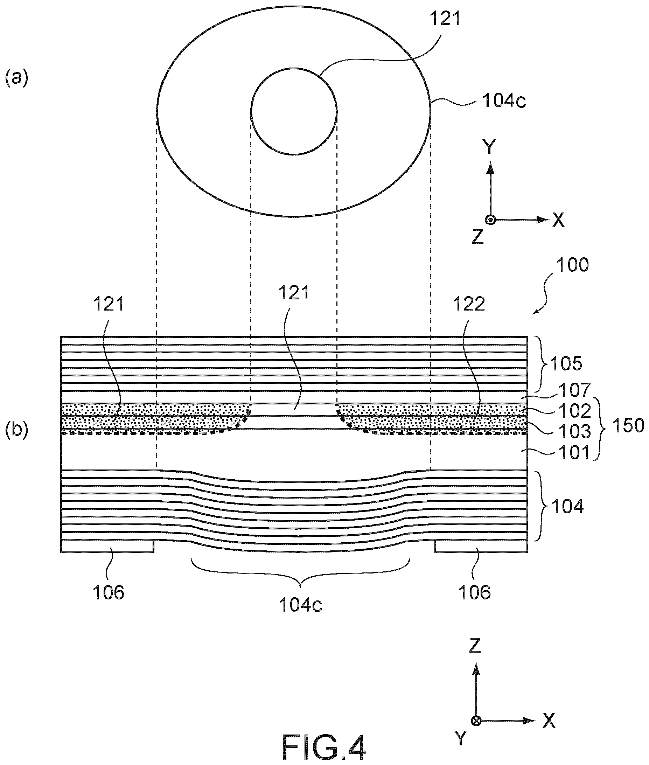

Fig. 4 is a schematic diagram showing a positional relationship between the current injection region 121 and the concave mirror 104c. Part (a) of Fig. 4 is a diagram of the current injection region 121 and the concave mirror 104c when viewed from the optical axis direction (Z direction) of laser light emitted from the VCSEL device 100, and Part (b) of Fig. 4 is a schematic cross-sectional view of the VCSEL device 100. As shown in Part (a) of Fig. 4, the concave mirror 104c is formed to include the current injection region 121 when viewed from the Z direction. Further, the concave mirror 104c is formed in a concave surface shape for collecting, in the current injection region 121, light that has entered from the side of the active layer 103.

Note that the plane figure of the current injection region 121 when viewed from the optical axis direction (Z direction) of laser light shown in Part (a) of Fig. 4 is a plane figure of a portion of the current injection region 121 having the smallest diameter in the layer surface direction (X-Y direction) as shown in Part (b) of Fig. 4. Since the diameter of the current injection region 121 increases as away from the interface between the second semiconductor layer 102 and the second electrode 106, the plane shape of the current injection region 121 is the shape of the current injection region 121 at the same interface.

### [Operation of VCSEL device]

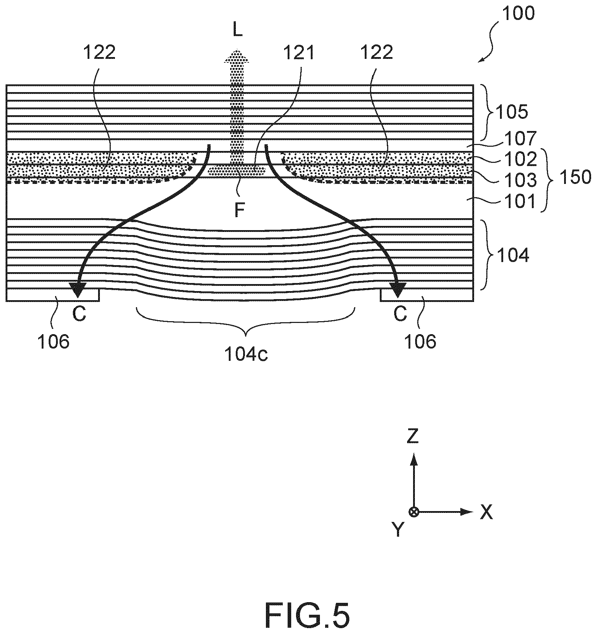

An operation of the VCSEL device 100 will be described. Fig. 5 is a schematic diagram showing an operation of the VCSEL device 100. When a voltage is applied between the first electrode 106 and the second electrode 107, a current flows between the first electrode 106 and the second electrode 107. The current is confined by the current confinement structure and injected to the current injection region 121 as shown by arrows C in Fig. 5.

This injected current causes spontaneous emission light F in the vicinity of the current injection region 121 of the active layer 103. The spontaneous emission light F travels in the stacking direction (Z direction) of the VCSEL device 100 and is reflected by the first light-reflecting layer 104 and the second light-reflecting layer 105.

Since the first light-reflecting layer 104 and the second light-reflecting layer 105 are configured to reflect light having the oscillation wavelength λ, the component of the spontaneous emission light having the oscillation wavelength λ forms a standing wave between the first light-reflecting layer 104 and the second light-reflecting layer 105 and is amplified by the active layer 103. When the injected current exceeds a threshold value, light forming a standing wave causes laser oscillation. Laser light L generated thereby is transmitted through the second light-reflecting layer 105 and is emitted from the VCSEL device 100 with the Z direction as the optical axis direction.

Here, in the VCSEL device 100, the concave mirror 104c is provided in the first light-reflecting layer 104. For this reason, light that has entered the first light-reflecting layer 104 is reflected in a direction according to the shape of the concave mirror 104c and is collected in the current injection region 121. For this reason, the optical field of the laser light L is controlled by the concave mirror 104c. Further, a current flowing through the VCSEL device 100 is controlled by the current injection region 121 as described above. That is, in the VCSEL device 100, the optical field and the current are controlled by separate structures.

### [Regarding plane figures of contour line of concave mirror and current injection region]

The plane figures of the contour line of the concave mirror 104c and the current injection region 121 will be described. Note that in the following description, the "plane figure" refers to the shape of the contour line and the shape of the current injection region 121 when viewed from the optical axis direction (Z direction) of the laser light L.

### <Regarding contour line of concave mirror>

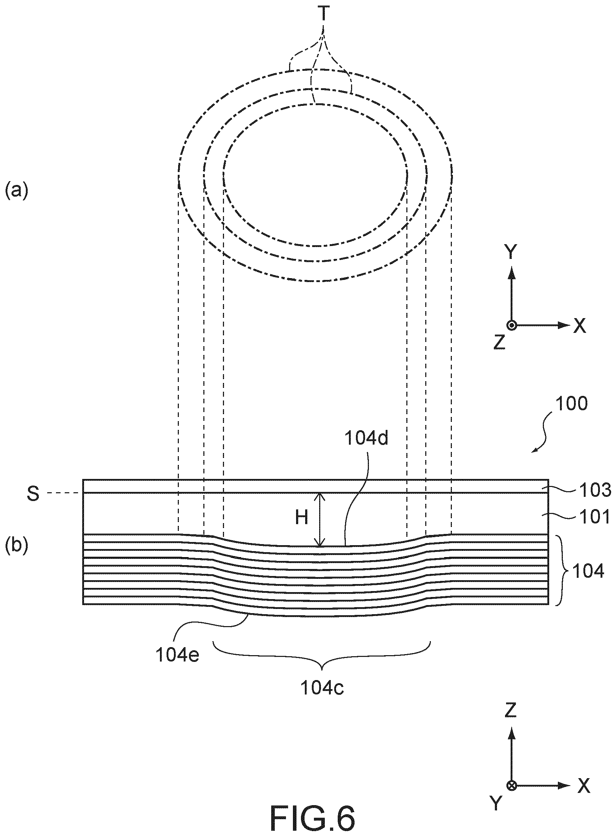

Fig. 6 is a schematic diagram showing contour lines of the concave mirror 104c. Part (a) of Fig. 6 is a plan view showing the plane figure of contour lines T of the concave mirror 104c, and Part (b) of Fig. 6 is a partial schematic cross-sectional view of the VCSEL device 100. As shown in Part (b) of Fig. 6, the interface between the first semiconductor layer 101 and the active layer 103 is defined as a reference surface S. The contour line T represents a height H of the concave surface 104d from the reference surface S using a line.

### <Regarding plane figure of contour line of concave mirror>

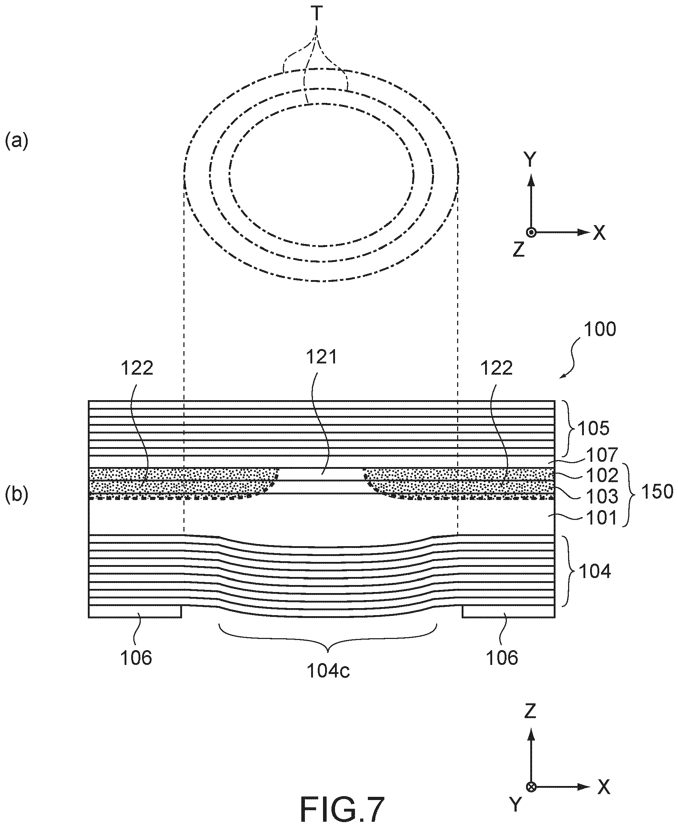

Fig. 7 is a schematic diagram showing an example of the plane figure of the contour lines T of the VCSEL device 100. Part (a) of Fig. 7 is a plan view showing the plane figure of the contour lines T, and Part (b) of Fig. 7 is a schematic cross-sectional view of the VCSEL device 100.

As shown in the figure, in the case where the plane figure of the contour line T is an ellipse, the substantial curvature of the concave mirror 104c differs between the polarization whose polarization direction is the longitudinal direction (X direction) of the ellipse (hereinafter, longitudinal polarization) and the polarization whose polarization direction is the lateral direction (Y direction) of the ellipse (hereinafter, lateral polarization). This is because the polarization is sensitive to the curvature of the concave mirror 104c oriented to match the polarization direction. For this reason, the effective resonator length (distance between the first light-reflecting layer 104 and the second light-reflecting layer 105) for the corresponding polarization differs, and the resonance wavelength differs between the longitudinal polarization and the lateral polarization.

For this reason, the wavelength overlap between the longitudinal polarization and the lateral polarization is weakened, and the longitudinal polarization and the lateral polarization are stabilized. This is because energy is easily exchanged between the longitudinal polarization and the lateral polarization when the wavelengths thereof are the same and energy is difficult to exchange when the wavelengths thereof differ from each other. As a result, in the case where the plane figure of the contour line T is an ellipse, the controllability of polarization is improved as compared with the case where the plane figure is a perfect circle.

Note that the plane figure of the contour line T is not limited to an ellipse, and can be a closed figure including a circle, an ellipse, a rectangle, or a combination of at least two of them, as described below. Of these, when the plane figure of the contour line T is a shape other than a perfect circle, the controllability of polarization can be improved in accordance with the principle described above.

### <Regarding plane figure of current injection region>

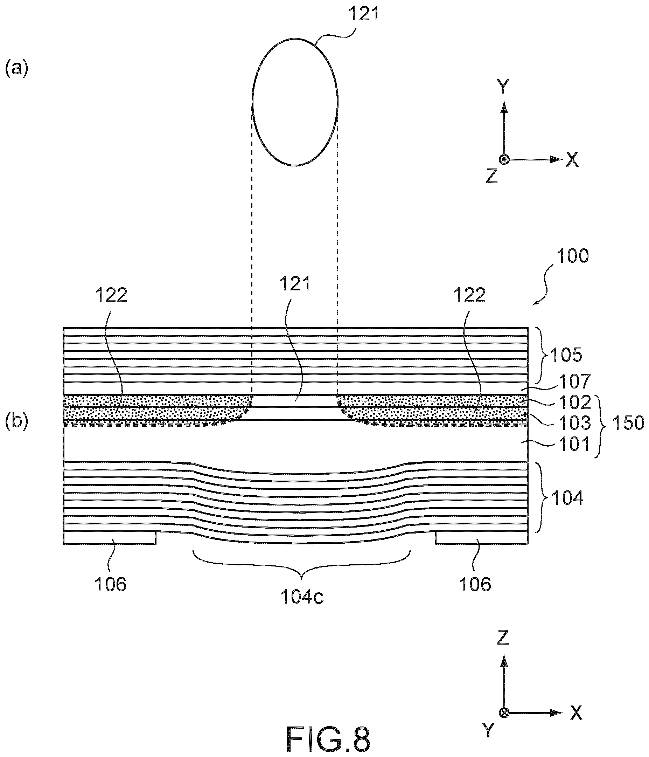

Fig. 8 is a schematic diagram showing another example of the plane figure of the current injection region 121 of the VCSEL device 100. Part (a) of Fig. 8 is a plan view showing the plane figure of the current injection region 121, and Part (b) of Fig. 8 is a schematic cross-sectional view of the VCSEL device 100.

As shown in the figure, in the case where the plane figure of the current injection region 121 is an ellipse, a current to be injected from the second electrode 106 to the central portion of the current injection region 121 increases. Since the second electrode 106 has certain film resistance, a current tends to flow into the outer periphery portion of the current injection region 121. This is because in the case where the plane figure of the current injection region 121 is an ellipse, the peripheral edge of the current injection region 121 in the lateral direction (X direction) approaches the central portion as compared with the case where the plane figure is a perfect circle.

When the current to be injected to the central portion of the current injection region 121 increases, the fundamental transverse mode is easily stabilized. The fundamental transverse mode is a profile of beam profiles (irradiation spot shapes) of the laser light L, in which the amount of light is the largest in the central portion and the amount of light gradually decreases along the peripheral portion. Note that the plane figure of the current injection region 121 is not limited to an ellipse, and can be a closed figure including a circle, an ellipse, a rectangle, or a combination of at least two of them, as described below. Of these, in the case where the plane figure of the current injection region 121 is a shape other than a perfect circle, the fundamental transverse mode can be easily stabilized in accordance with the principle described above.

### [Regarding relationship between concave mirror and current injection region]

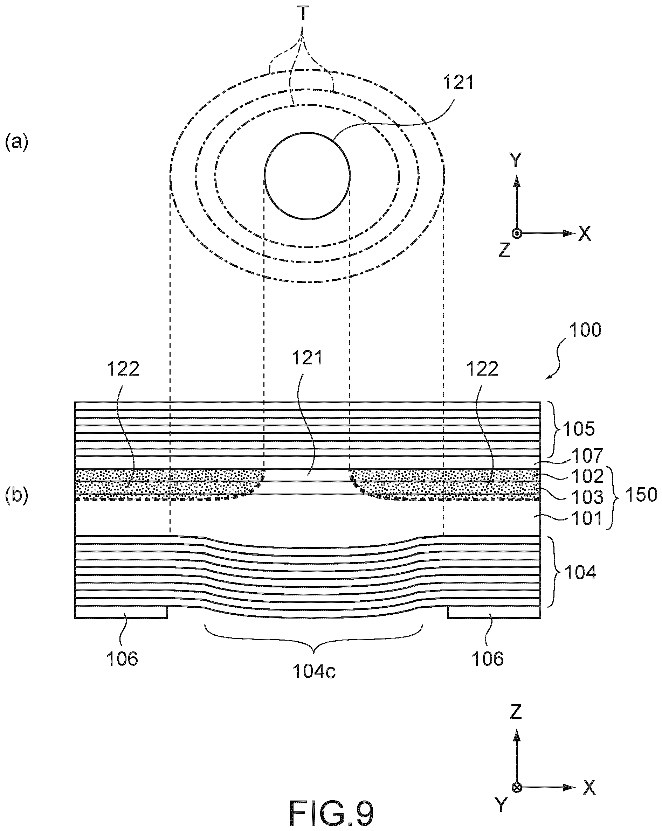

In the VCSEL device 100, the plane figure of the current injection region 121 (first figure) and the plane figure of the contour line T of the concave mirror 104c (second figure) have one of the following relationships. Fig. 9 to Fig. 23 are each a schematic diagram showing an example of the plane figure of the current injection region 121 and the plane figure of the contour line T. In each figure, Part (a) is a plan view showing the plane figures of the contour lines T and the current injection region 121, and Part (b) is a schematic cross-sectional view of the VCSEL device 100.

### <1. Dissimilarity>

The plane figure of the current injection region 121 and the plane figure of the contour line T can be dissimilar. Specifically, the plane figure of the current injection region 121 can be a closed figure including a circle, an ellipse, a rectangle, or a combination of at least two of them. The plane figure of the contour line T can be a closed figure including a circle, an ellipse, a rectangle, or a combination of at least two of them and be a figure dissimilar to the plane figure of the current injection region 121. Either one of the plane figure of the current injection region 121 or the plane figure of the contour line T may be a perfect circle. Further, the center of gravity of the plane figure of the current injection region 121 and the center of gravity of the plane figure of the contour line T can match. A specific example of the plane figure of the current injection region 121 and the plane figure of the contour line T in the case where the plane figure of the current injection region 121 and the plane figure of the contour line T are dissimilar will be described below.

As shown in Fig. 9, the plane figure of the current injection region 121 can be a perfect circle, and the plane figure of the contour line T can be an ellipse with the X direction as the longitudinal direction. The center of gravity of the plane figure of the current injection region 121 and the center of gravity of the plane figure of the contour line T match. The plane figure of the current injection region 121 can be, for example, a perfect circle having a diameter of 5 um, and the plane figure of the contour line T can be, for example, an ellipse with a ratio of longitudinal diameter to lateral diameter of 5:2.

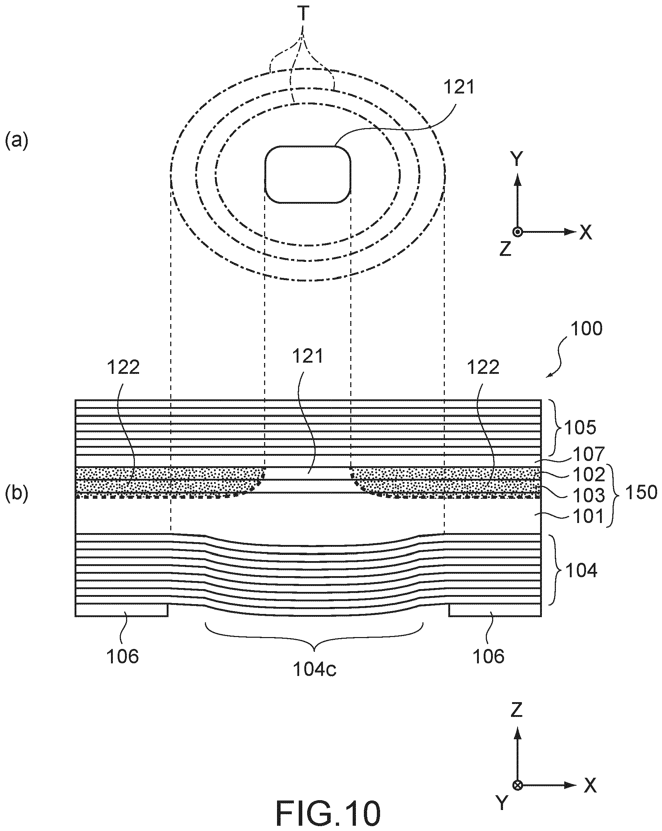

Further, as shown in Fig. 10, the plane figure of the current injection region 121 can be a rectangle with rounded corners with the X direction as the longitudinal direction, and the plane figure of the contour line T can be an ellipse with the X direction as the longitudinal direction. The center of gravity of the plane figure of the current injection region 121 and the center of gravity of the plane figure of the contour line T match. The plane figure of the current injection region 121 can be, for example, a rectangle with rounded corners having a long side of 5 um and a short side of 3 µm, the plane figure of the contour line T can be, for example, an ellipse with a ratio of longitudinal diameter to lateral diameter of 5:2.

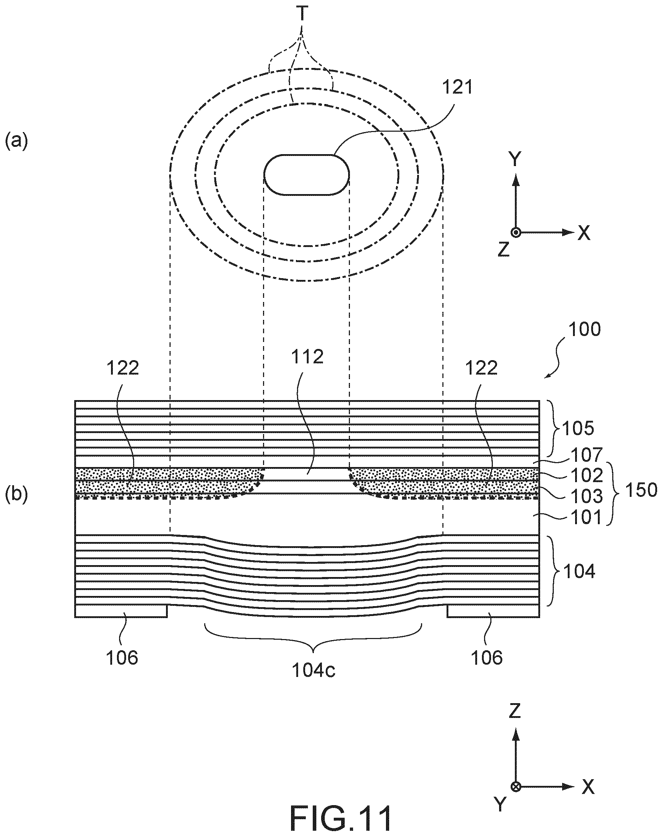

Further, as shown in Fig. 11, the plane figure of the current injection region 121 can be a rectangle with semicircular ends with the X direction as the longitudinal direction, and the plane figure of the contour line T can be an ellipse with the X direction as the longitudinal direction. The center of gravity of the plane figure of the current injection region 121 and the center of gravity of the plane figure of the contour line T match. The plane figure of the current injection region 121 can be, for example, a shape having a longitudinal width of 5 um and a lateral width of 2 um, and the plane figure of the contour line T can be, for example, an ellipse with a ratio of longitudinal diameter to lateral diameter of 5:2.

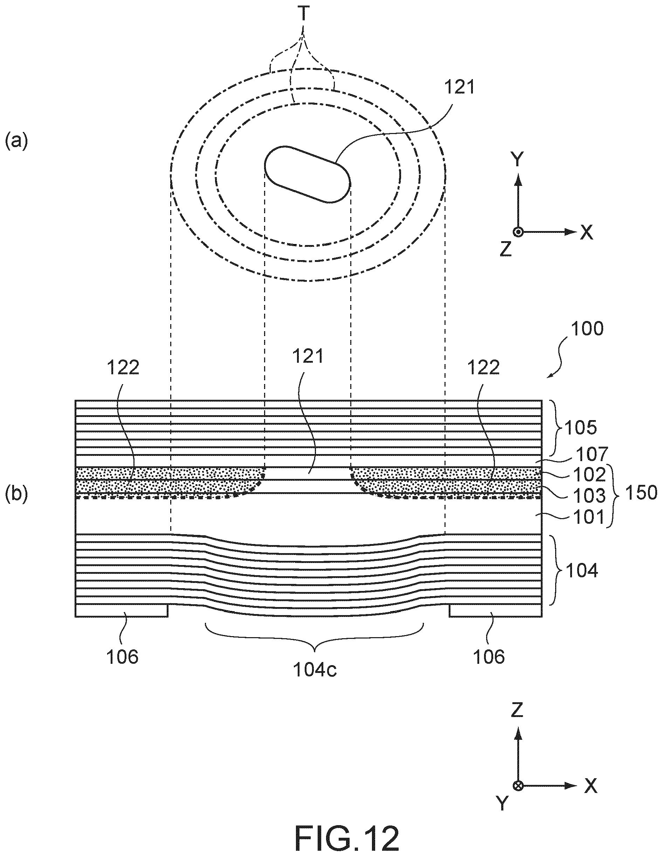

Further, as shown in Fig. 12, the plane figure of the current injection region 121 can be a rectangle with semicircular ends with a direction between the X direction and the Y direction as the longitudinal direction, and the plane figure of the contour line T can be an ellipse with the X direction as the longitudinal direction. The center of gravity of the plane figure of the current injection region 121 and the center of gravity of the plane figure of the contour line T match. The plane figure of the current injection region 121 can be, for example, a shape having a longitudinal width of 5 um and a lateral width of 2 um, and the plane figure of the contour line T can be, for example, an ellipse with a ratio of longitudinal diameter to lateral diameter of 5:2.

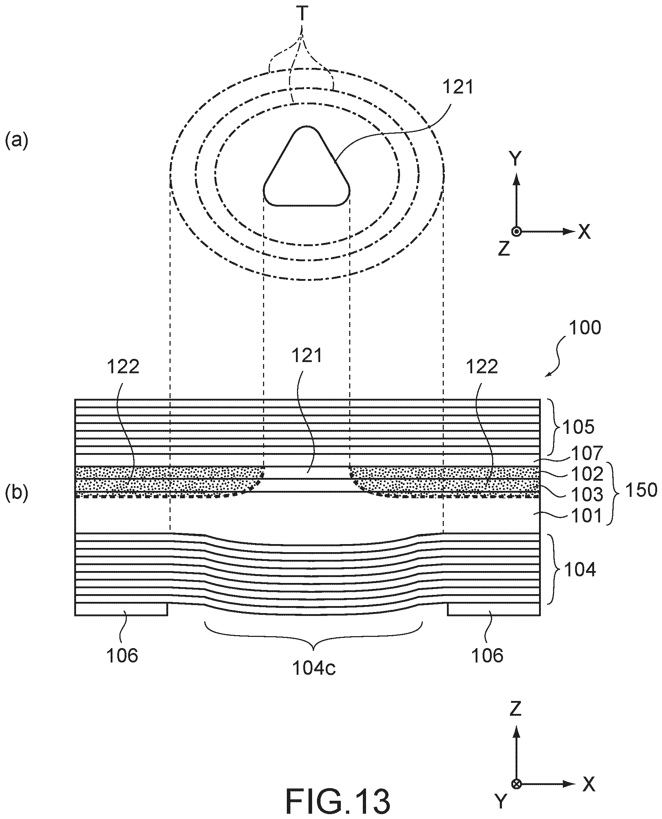

Further, as shown in Fig. 13, the plane figure of the current injection region 121 can be a triangle with rounded corners, and the plane figure of the contour line T can be an ellipse with the X direction as the longitudinal direction. The center of gravity of the plane figure of the current injection region 121 and the center of gravity of the plane figure of the contour line T match. The plane figure of the current injection region 121 can be, for example, a triangle with rounded corners having sides of 5 um, and the plane figure of the contour line T can be, for example, an ellipse with a ratio of longitudinal diameter to lateral diameter of 5:2.

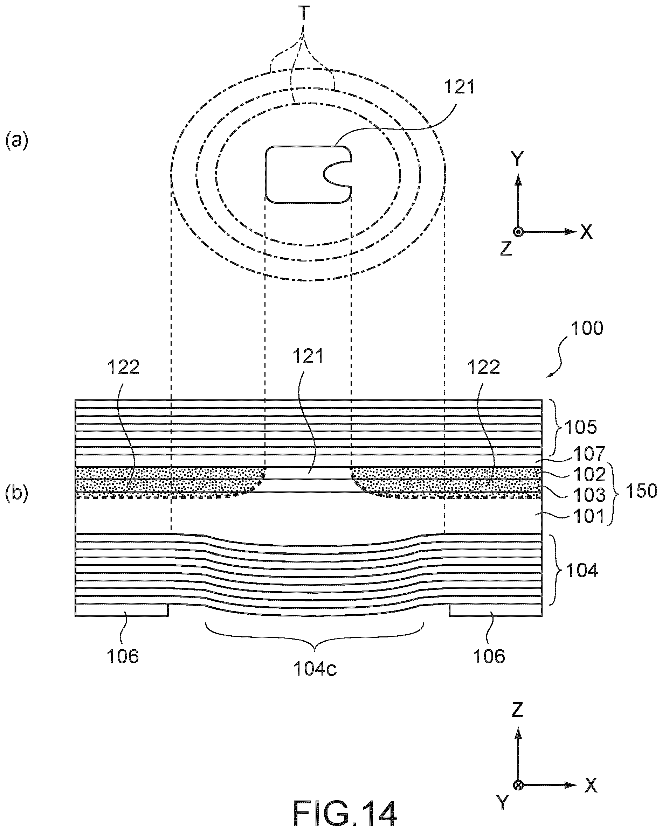

Further, as shown in Fig. 14, the plane figure of the current injection region 121 can be a shape obtained by combining a rectangle with rounded corners and an ellipse, and the plane figure of the contour line T can be an ellipse with the X direction as the longitudinal direction. The center of gravity of the plane figure of the current injection region 121 and the center of gravity of the plane figure of the contour line T match. The plane figure of the current injection region 121 can be, for example, a shape having a long side of 5 um and a short side of 3 um, and the plane figure of the contour line T can be, for example, an ellipse with a ratio of longitudinal diameter to lateral diameter of 5:2.

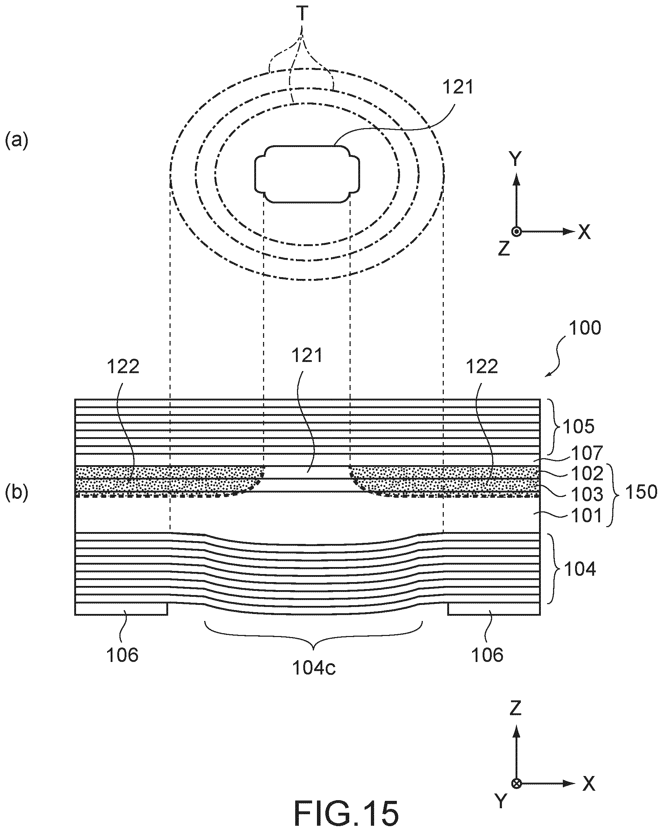

Further, as shown in Fig. 15, the plane figure of the current injection region 121 can be a shape obtained by combining two rectangles with rounded corners, and the plane figure of the contour line T can be an ellipse with the X direction as the longitudinal direction. The center of gravity of the plane figure of the current injection region 121 and the center of gravity of the plane figure of the contour line T match. The plane figure of the current injection region 121 can be, for example, a shape having a long side of 5 um and a short side of 3 um, and the plane figure of the contour line T can be, for example, an ellipse with a ratio of longitudinal diameter to lateral diameter of 5:2.

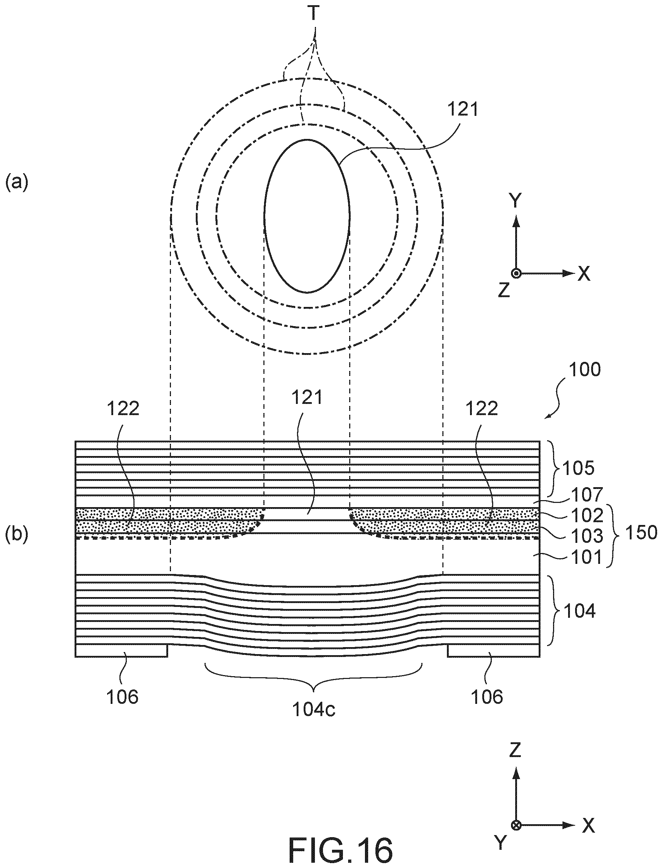

Further, as shown in Fig. 16, the plane figure of the current injection region 121 can be an ellipse with the Y direction as the longitudinal direction, and the plane figure of the contour line T can be a perfect circle. The center of gravity of the plane figure of the current injection region 121 and the center of gravity of the plane figure of the contour line T match. The plane figure of the current injection region 121 can be, for example, an ellipse having a longitudinal width of 5 um and a lateral width of 3 µm.

As shown in Fig. 9 to Fig. 16, the plane figure of the current injection region 121 and the plane figure of the contour line T can be dissimilar. Both the plane figure of the current injection region 121 and the plane figure of the contour line T are not limited to those described above, and only need to be a closed figure including a circle, an ellipse, a rectangle, or a combination of at least two of them and be dissimilar.

In the case where the plane figure of the current injection region 121 and the plane figure of the contour line T are dissimilar, the gain of polarization having a specific polarization direction is improved. This is because the substantial curvature of the concave mirror 104c differs depending on the polarization direction and the degree of passing through a region of the current injection region 121 where the injected current is large differs, so that the gain received from the injected current differs depending on the polarization direction. This stabilizes the polarization with a specific direction as the polarization direction, and therefore, it is possible to improve the controllability of polarization of the VCSEL device 100.

### <2. Similar and non-perfect circle>

The plane figure of the current injection region 121 and the plane figure of the contour line T can be similar and a non-perfect circle. Specifically, the plane figure of the current injection region 121 can be a closed figure including a circle, an ellipse, a rectangle, or a combination of at least two of them, and be a non-perfect circle. The plane figure of the contour line T can be a closed figure including a circle, an ellipse, a rectangle, or a combination of at least two of them, be a non-perfect circle, and be a figure similar to the plane figure of the current injection region 121. Further, the center of gravity of the plane figure of the current injection region 121 and the center of gravity of the plane figure of the contour line T can match. A specific example of the plane figure of the current injection region 121 and the plane figure of the contour line T in the case where the plane figure of the current injection region 121 and the plane figure of the contour line T are similar and a non-perfect circle will be described.

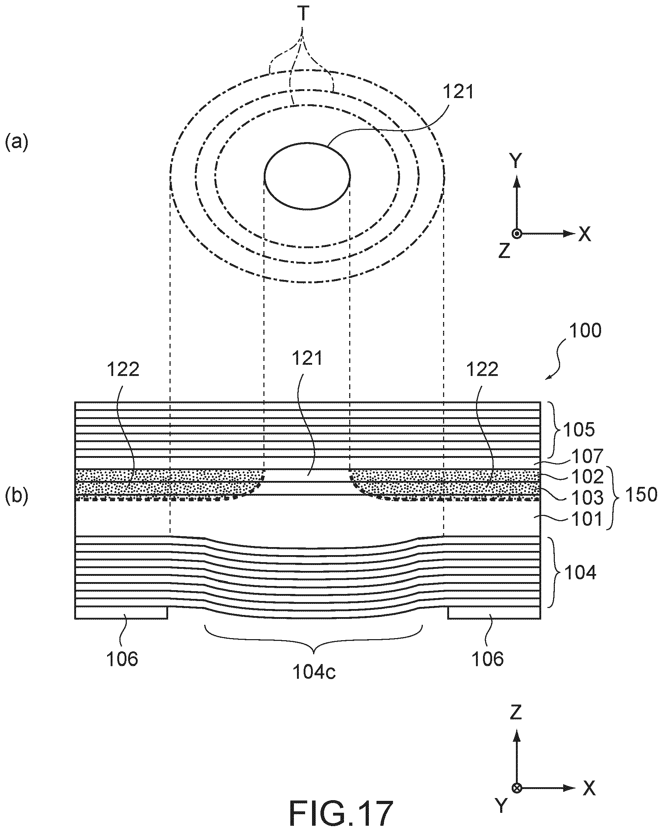

As shown in Fig. 17, the plane figure of the current injection region 121 can be an ellipse with the X direction as the longitudinal direction, and the plane figure of the contour line T can be an ellipse similar to the plane figure of the current injection region 121. The center of gravity of the plane figure of the current injection region 121 and the center of gravity of the plane figure of the contour line T match. The plane figure of the current injection region 121 can be, for example, an ellipse having a longitudinal diameter of 5 um and a lateral diameter of 2 um, and the plane figure of the contour line T can be, for example, an ellipse with a ratio of longitudinal diameter to lateral diameter of 5:2.

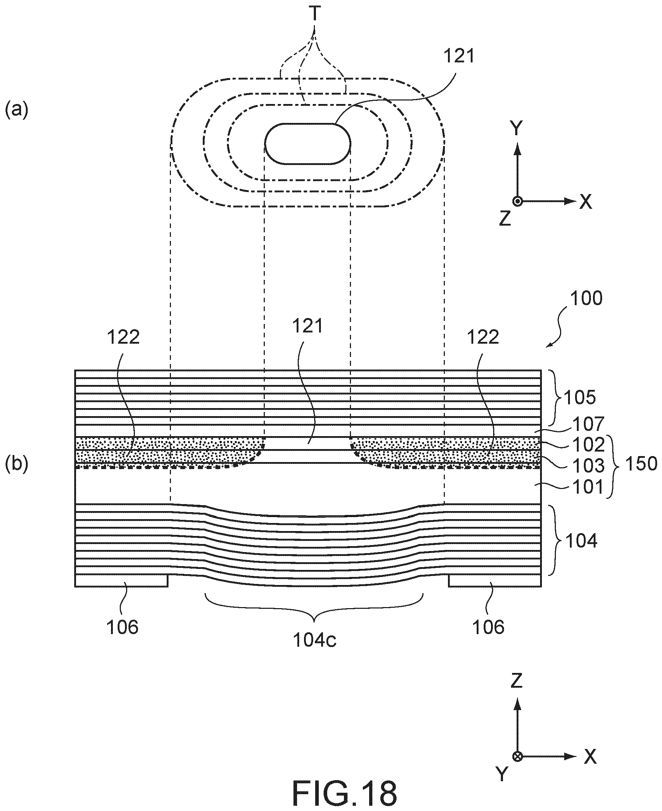

Further, as shown in Fig. 18, the plane figure of the current injection region 121 can be a rectangle with semicircular ends with the X direction as the longitudinal direction, and the plane figure of the contour line T can be a rectangle with semicircular ends similar to the plane figure of the current injection region 121. The center of gravity of the plane figure of the current injection region 121 and the center of gravity of the plane figure of the contour line T match. The plane figure of the current injection region 121 can be, for example, a shape having a longitudinal width of 5 um and a lateral width of 2 um, and the plane figure of the contour line T can be, for example, a shape with a ratio of longitudinal width: lateral width of 5:2.

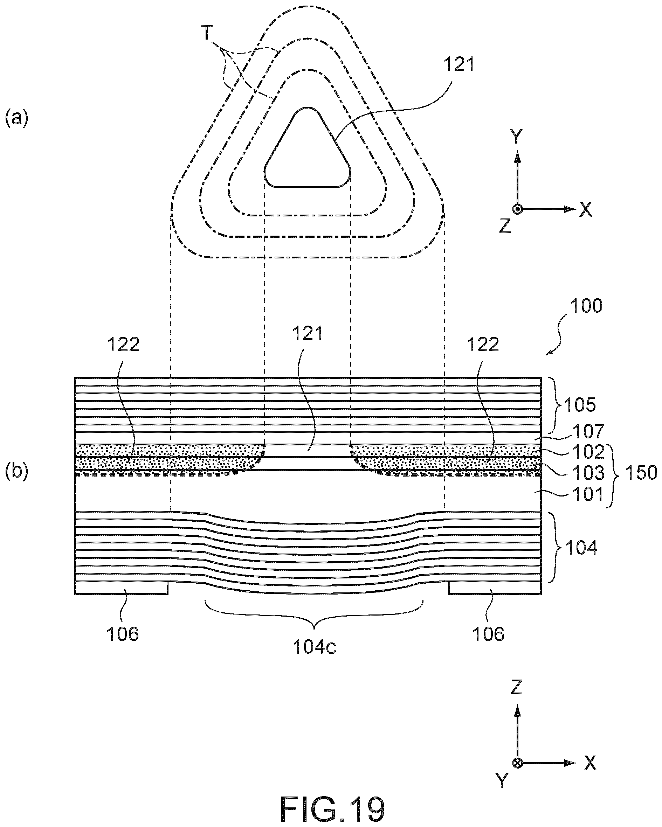

Further, as shown in Fig. 19, the plane figure of the current injection region 121 can be a triangle with rounded corners, and the plane figure of the contour line T can be a triangle with rounded corners similar to the plane figure of the current injection region 121. The center of gravity of the plane figure of the current injection region 121 and the center of gravity of the plane figure of the contour line T match. The plane figure of the current injection region 121 can be, for example, a triangle with rounded corners having sides of 5 µm.

As shown in Fig. 17 to Fig. 19, the plane figure of the current injection region 121 and the plane figure of the contour line T can be similar and a non-perfect circle. Both the plane figure of the current injection region 121 and the plane figure of the contour line T are not limited to those described above, and only needs to be a closed figure including a circle, an ellipse, a rectangle, or a combination of at least two of them, be a non-perfect circle, and be similar.

In the case where the plane figure of the contour line T is a non-perfect circle, since the substantial curvature of the concave mirror 104c differs depending on the polarization direction, the effective resonator length for the polarization in the respective polarization directions differs, and the resonance wavelength differs between the respective polarizations. For this reason, the wavelength overlap between the respective polarizations is weakened, and the respective polarizations are stabilized.

Further, in the case where the plane figure of the current injection region 121 is a non-perfect circle, since the peripheral edge of the current injection region 121 approaches the central portion, a current to be injected from the second electrode 106 to the central portion of the current injection region 121 increases and the fundamental transverse mode becomes easier to stabilize. Here, in the case where the plane figure of the contour line T and the plane figure of the current injection region 121 are similar, since the effect of improving the stability of polarization and the effect of improving the stability of the fundamental transverse mode described above are superimposed, it is possible to improve the controllability of polarization of the VCSEL device 100.

### <3. Difference in center of gravity>

The center of gravity of the plane figure of the current injection region 121 and the center of gravity of the plane figure of the contour line T can be different from each other. Specifically, the plane figure of the current injection region 121 can be a closed figure including a circle, an ellipse, a rectangle, or a combination of at least two of them. The plane figure of the contour line T can be a closed figure including a circle, an ellipse, a rectangle, or a combination of at least two of them, and the center of gravity thereof can be different from that of the plane figure of the current injection region 121. The distance between the center of gravity of the plane figure of the current injection region 121 and the center of gravity of the plane figure of the contour line T in the plane (X-Y plane) perpendicular to the optical axis direction (Z direction) is suitably 0.03 um or more. The plane figure of the current injection region 121 and the plane figure of the contour line T may be similar but do not necessarily need to be similar. A specific example of the plane figure of the current injection region 121 and the plane figure of the contour line T in the case where the center of gravity of the plane figure of the current injection region 121 and the center of gravity of the plane figure of the contour line T are different from each other will be described below.

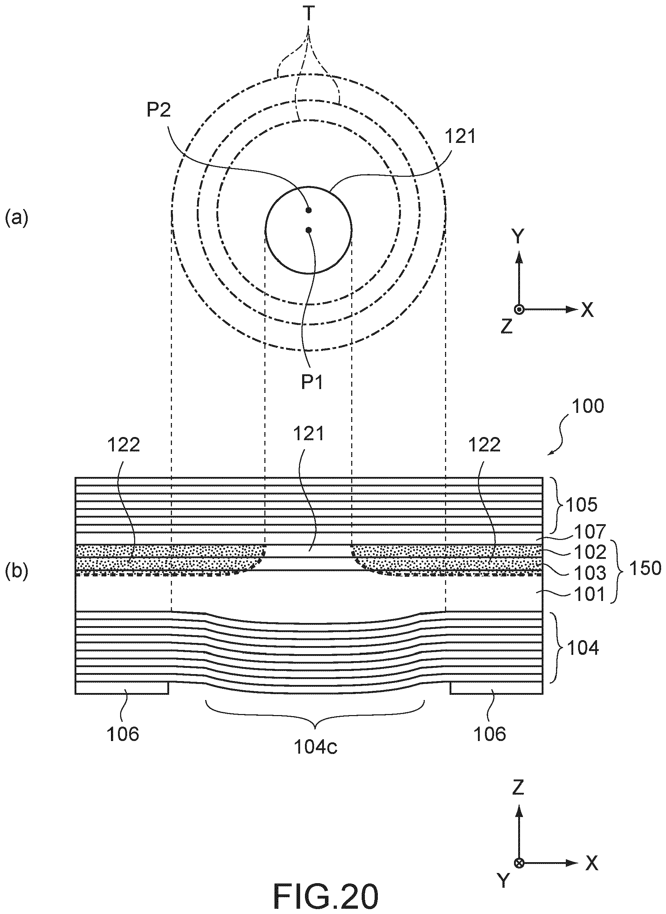

As shown in Fig. 20, the plane figure of the current injection region 121 can be a perfect circle, and also the plane figure of the contour line T can be a perfect circle. A center of gravity P1 of the plane figure of the current injection region 121 and a center of gravity P2 of the plane figure of the contour line T are different from each other in the Y direction. The plane figure of the current injection region 121 can be, for example, a perfect circle having a diameter of 4 um. The distance between the center of gravity P1 and the center of gravity P2 (in the Y direction) can be, for example, 0.5 µm.

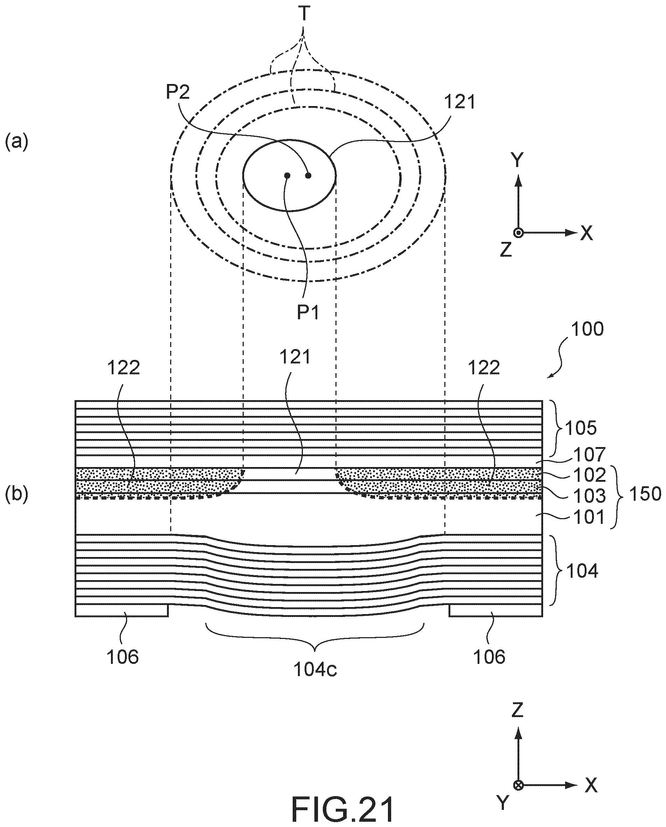

Further, as shown in Fig. 21, the plane figure of the current injection region 121 can be an ellipse with the X direction as the longitudinal direction, and the plane figure of the contour line T can be an ellipse with the X direction as the longitudinal direction. The center of gravity P1 of the plane figure of the current injection region 121 and the center of gravity P2 of the plane figure of the contour line T are different from each other in their longitudinal directions (X direction). The plane figure of the current injection region 121 can be, for example, an ellipse having a longitudinal diameter of 8 um and a lateral diameter of 4 um, and the plane figure of the contour line T can be, for example, an ellipse with a ratio of longitudinal diameter to lateral diameter of 5:2. The distance between the center of gravity P1 and the center of gravity P2 (in the X direction) can be, for example, 0.5 µm.

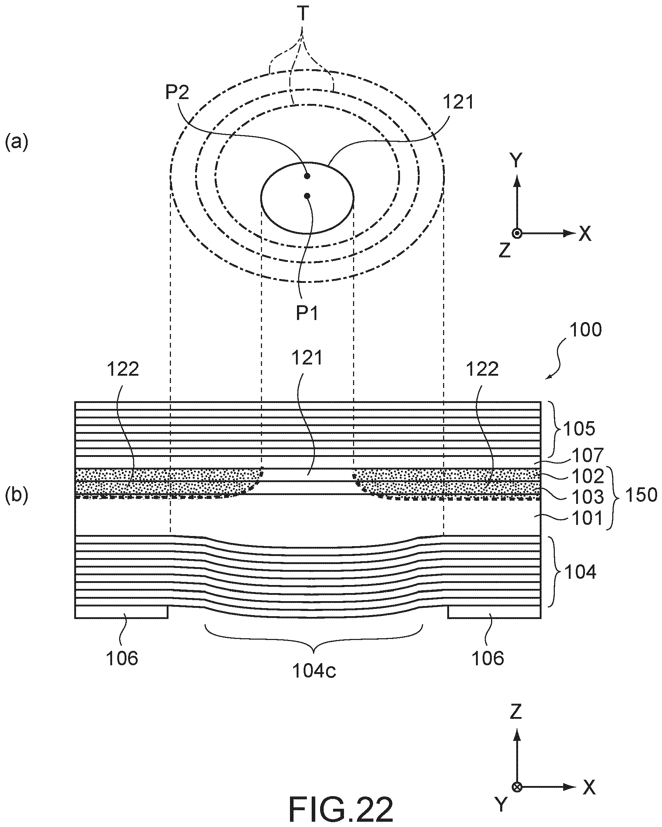

Further, as shown in Fig. 22, the plane figure of the current injection region 121 can be an ellipse with the X direction as the longitudinal direction, and the plane figure of the contour line T can be an ellipse with the X direction as the longitudinal direction. The center of gravity P1 of the plane figure of the current injection region 121 and the center of gravity P2 of the plane figure of the contour line T are different from each other in their lateral directions (Y direction). The plane figure of the current injection region 121 can be, for example, an ellipse having a longitudinal diameter of 8 um and a lateral diameter of 4 um, and the plane figure of the contour line T can be, for example, an ellipse with a ratio of longitudinal diameter to lateral diameter of 5:2. The distance between the center of gravity P1 and the center of gravity P2 (in the Y direction) can be, for example, 0.5 µm.

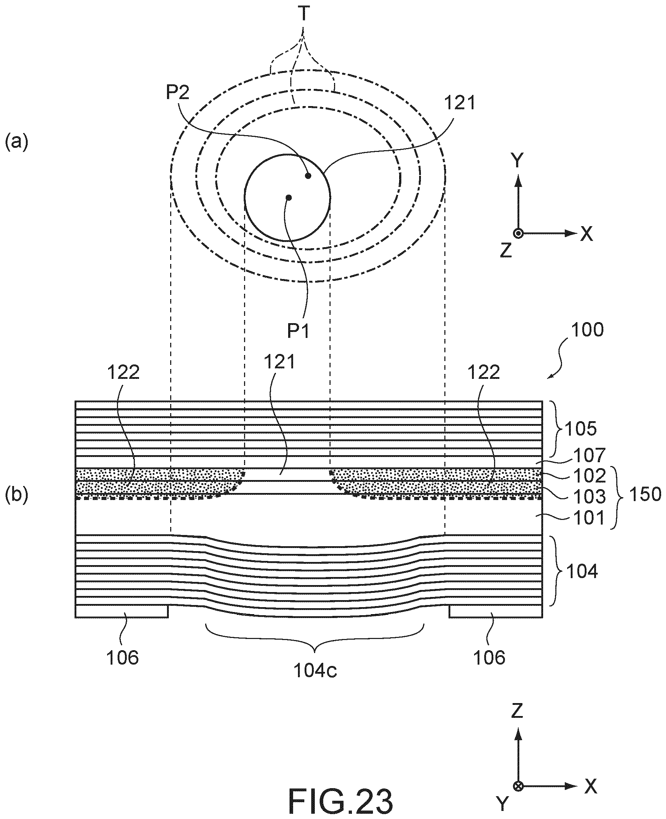

Further, as shown in Fig. 23, the plane figure of the current injection region 121 can be an ellipse with the X direction as the longitudinal direction, and the plane figure of the contour line T can be a perfect circle. The center of gravity P1 of the plane figure of the current injection region 121 and the center of gravity P2 of the plane figure of the contour line T are different from each other in the longitudinal direction (X direction) and the lateral direction (Y direction) of the current injection region 121. The plane figure of the current injection region 121 can be, for example, a perfect circle having a diameter of 4 um, and the plane figure of the contour line T can be, for example, an ellipse with a ratio of longitudinal diameter to lateral diameter of 5:2. The distance between the center of gravity P1 and the center of gravity P2 (X-Y direction) can be, for example, 0.5 µm.

As shown in Fig. 20 to Fig. 23, the center of gravity of the plane figure of the current injection region 121 and the center of gravity of the plane figure of the contour line T can be different from each other. Both the plane figure of the current injection region 121 and the plane figure of the contour line T are not limited to those described above, and only need to be a closed figure including a circle, an ellipse, a rectangle, or a combination of at least two of them.

In the case where the plane figure of the current injection region 121 and the center of gravity of the plane figure of the contour line T are different from each other, the gain of polarization having a specific polarization direction is improved. This is because the degree of passing through a region of the current injection region 121 where the injected current is large differs depending on the polarization direction when the centers of gravity of the plane figures differ, so that the gain received from the injected current differs depending on the polarization direction. This stabilizes the polarization with a specific direction as the polarization direction, and therefore, it is possible to improve the controllability of polarization of the VCSEL device 100.

### [Effects of VCSEL device]

As described above, in the VCSEL device 100, when the plane figure of the current injection region 121 and the plane figure of the contour line T have one of the relationships described above, asymmetry in the lateral direction (X-Y direction) is provided with respect to light and a current, and it is possible to improve the controllability of polarization of the VCSEL device 100. Since the VCSEL device 100 does not use the asymmetry of crystals for polarization control, it is also possible to prepare the VCSEL device 100 using a substrate (C-plane substrate or the like) in which crystals have no asymmetry.

### [Method of producing VCSEL device]

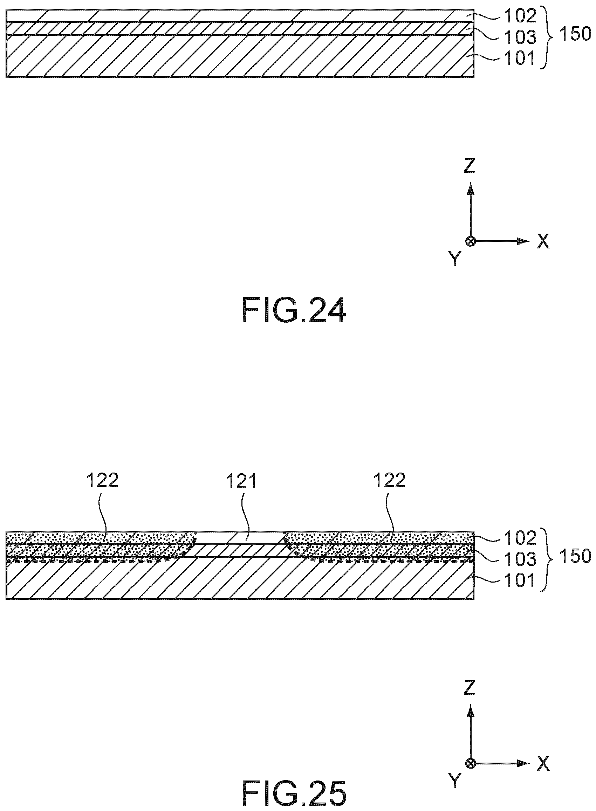

A method of producing the VCSEL device 100 will be described. Fig. 24 to Fig. 26 are each a schematic diagram showing a method of producing the VCSEL device 100. First, as shown in Fig. 24, the stacked body 150 is prepared. The stacked body 150 can be prepared by stacking the active layer 103 and the second semiconductor layer 102 on the first semiconductor layer 101 (substrate). The active layer 103 and the second semiconductor layer 102 can be stacked by a metal organic-chemical vapor deposition (MOCVD) method or the like.

Subsequently, as shown in Fig. 25, the insulation region 122 is formed. The insulation region 122 can be formed by implanting ions into the stacked body 150 from the side of the second semiconductor layer 102. At this time, by covering a partial region of the second semiconductor layer 102 with a mask, the current injection region 121 that is a region into which ions are not implanted can be formed.

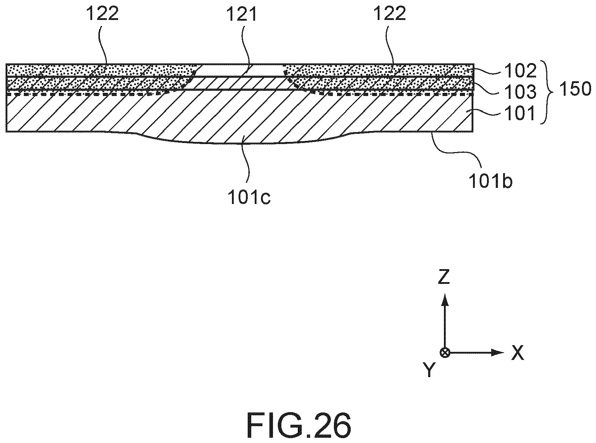

Subsequently, as shown in Fig. 26, the base 101c is formed on the second surface 101b of the first semiconductor layer 101. Specifically, after polishing the second surface 101b, a resist layer patterned on the second surface 101b is formed, and the resist layer is heated and reflowed to obtain a resist pattern. The resist pattern is made to have the same shape as (or a shape similar to) that of the base 101c. Subsequently, the resist pattern and the second surface 101b are etched, and thus, the base 101c can be formed. This etching can be, for example, reactive ion etching (RIE) .

Subsequently, the first light-reflecting layer 104, the second light-reflecting layer 105, the first electrode 106, and the second electrode 107 are formed, and thus, the VCSEL device 100 shown in Fig. 1 can be prepared. Each of these layers can be formed by a sputtering method, a vacuum deposition method, or the like. When stacking the first light-reflecting layer 104 of the first semiconductor layer 101, since the base 101c is provided on the second surface 101b, the concave mirror 104c is formed.

The VCSEL device 100 can be produced in this way. Note that the method of producing the VCSEL device 100 is not limited the one shown here, and the VCSEL device 100 can be produced by another production method.

### [Another configuration of VCSEL device]

Although the interface between the first semiconductor layer 101 and the active layer 103 is defined as the reference surface S and the contour line T of the concave mirror 104c is a line representing the height of the concave surface 104d from the reference surface S (see Fig. 6) in the above description, a line representing the height of the convex surface 104e from the reference surface S may be used as the contour line T. Further, the reference surface S may be the interface between the second electrode 107 and the second light-reflecting layer 105 instead of the interface between the first semiconductor layer 101 and the active layer 103.

Further, although the concave mirror 104c has been stacked on the base 101c provided on the first semiconductor layer 101 to have a concave mirror shape, the present technology is not limited thereto. A structure that has a shape similar to that of the base 101c and is formed of a dielectric material, a synthetic resin, or the like may be provided on the second surface 101b (see Fig. 2) of the first semiconductor layer 101, and the concave mirror 104c may be formed on the first light-reflecting layer 104 by the structure.

Further, although the first semiconductor layer 101 has been formed of an n-type semiconductor material and the second semiconductor layer 102 has been formed of a p-type semiconductor material, the first semiconductor layer 101 may be formed of a p-type semiconductor material and the second semiconductor layer 102 may be formed of an n-type semiconductor material. Further, the VCSEL device 100 may have another configuration capable of realizing the operation of the VCSEL device 100 described above, instead of the above-mentioned configurations.

### (Second embodiment)

A VCSEL (Vertical Cavity Surface Emitting Laser) device according to a second embodiment of the present technology will be described. The VCSEL device according to this embodiment is different from the VCSEL device according to the first embodiment mainly in the current confinement structure.

### [Structure of VCSEL device]

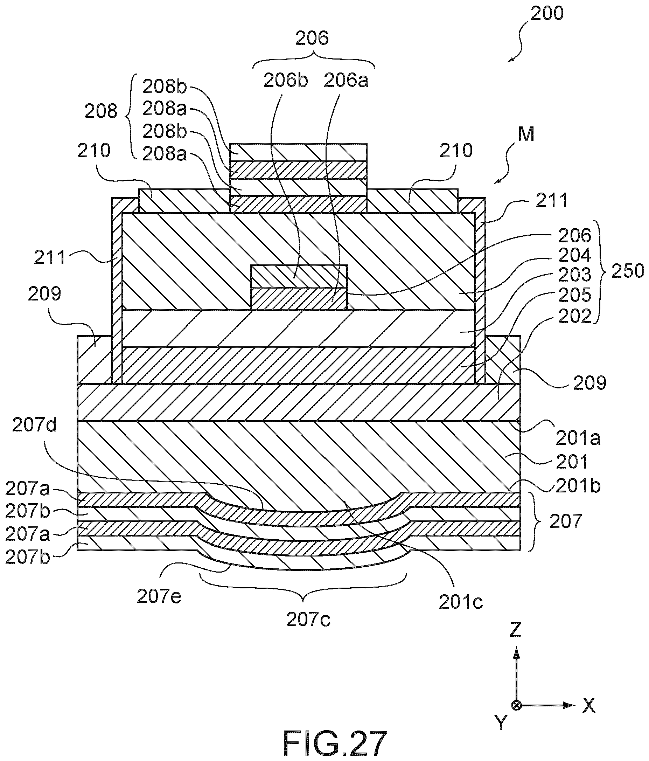

Fig. 27 is a cross-sectional view of a VCSEL device 200 according to this embodiment. As shown in the figure, the VCSEL device 200 includes a substrate 201, a first semiconductor layer 202, a second semiconductor layer 203, a third semiconductor layer 204, an active layer 205, a tunnel junction layer 206, a first light-reflecting layer 207, a second light-reflecting layer 208, a first electrode 209, a second electrode 210, and an insulation film 211. Of these, the first semiconductor layer 202, the second semiconductor layer 203, the third semiconductor layer 204, the active layer 205, and the tunnel junction layer 206 are collectively referred to as a stacked body 250.

Each of these layers has a layer surface direction along the X-Y plane, and the first light-reflecting layer 207, the substrate 201, the first semiconductor layer 202, the active layer 205, the second semiconductor layer 203, the third semiconductor layer 204, and the second light-reflecting layer 208 are stacked in this order. Therefore, the stacked body 250 is disposed between the first light-reflecting layer 207 and the second light-reflecting layer 208.

The substrate 201 supports each layer of the VCSEL device 200. The substrate 201 can be, for example, a (101)-plane semi-insulating InP substrate. As shown in Fig. 27, the substrate 201 has a first surface 201a on the side of the active layer 205 and a second surface 201b on the side opposite to the active layer 205. A base 201c is provided on the side of the second surface 101b of the substrate 201. The base 201c is a portion of the second surface 201b that protrudes in a convex curved surface shape and has, for example, a spherical lens shape. Further, the shape of the base 201c is not limited to the spherical lens shape as long as the second surface 201b is a convex curved surface.

The first semiconductor layer 202 is a layer that is formed of a semiconductor having a first conductivity type and transports carriers to the active layer 205. The first conductivity type can be an n-type, and the first semiconductor layer 202 can be a layer formed of, for example, n-InP. The second semiconductor layer 203 is a layer that is formed a semiconductor having a second conductivity type and transports carriers to the active layer 205. The second conductivity type can be a p-type, and the second semiconductor layer 203 can be a layer formed of, for example, p-InP. The third semiconductor layer 204 is a layer that is formed of a semiconductor having a first conductivity type and transports carriers to the tunnel junction layer 206. The third semiconductor layer 204 can be a layer formed of, for example, n-InP.

The active layer 205 is a layer that is disposed between the first semiconductor layer 202 and the second semiconductor layer 203 and emits light by carrier recombination. The active layer 205 has a multiple quantum well structure in which a quantum well layer and a barrier layer are alternately stacked to obtain a plurality of layers, the quantum well layer can be formed of, for example, InGaAsP, and the barrier layer can be formed of, for example, InGaAsP having a composition different from that of the quantum well layer. Further, the active layer 205 only needs to be a layer that emits light by carrier recombination instead of the multiple quantum well structure.

The tunnel junction layer 206 forms a buried tunnel junction. The tunnel junction layer 206 is disposed between the central portion of the second semiconductor layer 203 and the central portion of the third semiconductor layer 204. The tunnel junction layer 206 includes a first layer 206a on the side of the second semiconductor layer 203 and a second layer 206b on the side of the third semiconductor layer 204. The first layer 206a is a layer of the second conductivity type with a high impurity concentration, and can be, for example, a layer formed of p⁺-AlInGaAs. The second layer 206b is a layer of the first conductivity type with a high impurity concentration, and can be, for example, n⁺-InP.

As shown in Fig. 27, the outer periphery portions of the active layer 205, the second semiconductor layer 203, and the third semiconductor layer 204 are removed to form a mesa (plateau structure) M. The tunnel junction layer 206 is disposed to be located in the central portion of the mesa M when viewed from the Z direction.

The first light-reflecting layer 207 reflects light of a specific wavelength (hereinafter, a wavelength λ) and causes light of a wavelength other than that to be transmitted therethrough. The wavelength λ is a specific wavelength within, for example, 1300 to 1600 nm. As shown in Fig. 27, the first light-reflecting layer 207 can be a DBR (Distributed Bragg Reflector) including a multilayer light-reflecting film in which a high-refractive index layer 207a and a low-refractive index layer 207b having an optical film thickness of λ/4 are alternately stacked to obtain a plurality of layers. The second light-reflecting layer 207 may be a semiconductor DBR formed of a semiconductor material, or may be a dielectric DBR formed of a dielectric material.

The first light-reflecting layer 207 includes a concave mirror 207c. The first light-reflecting layer 207 is stacked on the second surface 201b of the substrate 201 to have a certain thickness, the surface thereof on the side of the stacked body 250 forms a concave surface 207d in accordance with the shape of the base 201c provided on the second surface 201b, and the surface on the side opposite to the stacked body 250 forms a convex surface 207e. As a result, the concave mirror 207c is formed in the first light-reflecting layer 207. It is suitable that in the concave mirror 207c, the radius of curvature (ROC) of the concave surface 207d is 1000 um or less and the surface accuracy (RMS: Root Mean Square) is 1 nm or less. For example, in the case where the thickness of the substrate 201 is 100 µm, the radius of curvature of the concave surface 207d can be 400 um.

The second light-reflecting layer 208 reflects light of the wavelength λ and causes light of a wavelength other than that to be transmitted therethrough. As shown in Fig. 27, the second light-reflecting layer 208 can be a DBR (Distributed Bragg Reflector) including a multilayer light-reflecting film in which a high-refractive index layer 208a and a low-refractive index layer 208b having an optical film thickness of λ/4 are alternately stacked to obtain a plurality of layers. The second light-reflecting layer 208 may be a semiconductor DBR formed of a semiconductor material, or may be a dielectric DBR formed of a dielectric material.

The first electrode 209 is provided around the mesa M on the first semiconductor layer 202 and functions as one electrode of the VCSEL device 200. The first electrode 209 can include, for example, a single-layer metal film formed of Au, Ni, Ti, or the like, or a multiplayer metal film formed of Ti/Au, Ag/Pd, Ni/Au/Pt, or the like.

The second electrode 210 is provided around the second light-reflecting layer 208 on the third semiconductor layer 204 and functions as the other electrode of the VCSEL device 200. The second electrode 210 can include, for example, a single-layer metal film formed of Au, Ni, Ti, or the like, or a multiplayer metal film formed of Ti/Au, Ag/Pd, Ni/Au/Pt, or the like. The insulation film 211 is provided around the second electrode 210 on the side surface of the mesa M and the upper surface of the mesa M to insulate the outer periphery of the mesa M. The insulation film 211 is formed of an arbitrary insulating material.

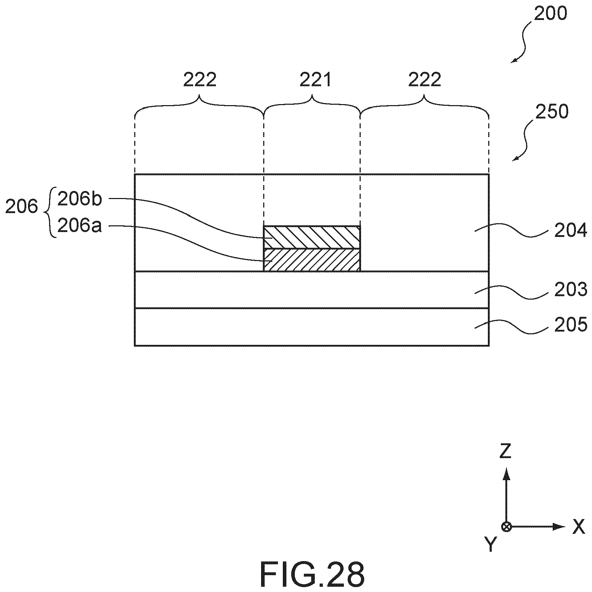

In the VCSEL device 200, a current confinement structure is formed in the stacked body 250 by the tunnel junction layer 206. Fig. 28 is a schematic diagram showing the current confinement structure. As shown in the figure, the current confinement structure has a current injection region 221 and an insulation region 222. The current injection region 221 is a region in which a tunnel junction is formed by the tunnel junction layer 206 (tunnel junction region), and causes a current to pass therethrough by the tunnel junction. The insulation region 222 is a region that surrounds the current injection region 221 in the layer surface direction (X-Y direction) and does not cause a current to pass therethrough because no tunnel junction is formed (non-tunnel-junction region). Since a current flowing through the VCSEL device 200 cannot pass through the insulation region 222, the current concentrates in the current injection region 221. That is, a current confinement structure is formed by the current injection region 221 and the insulation region 222.

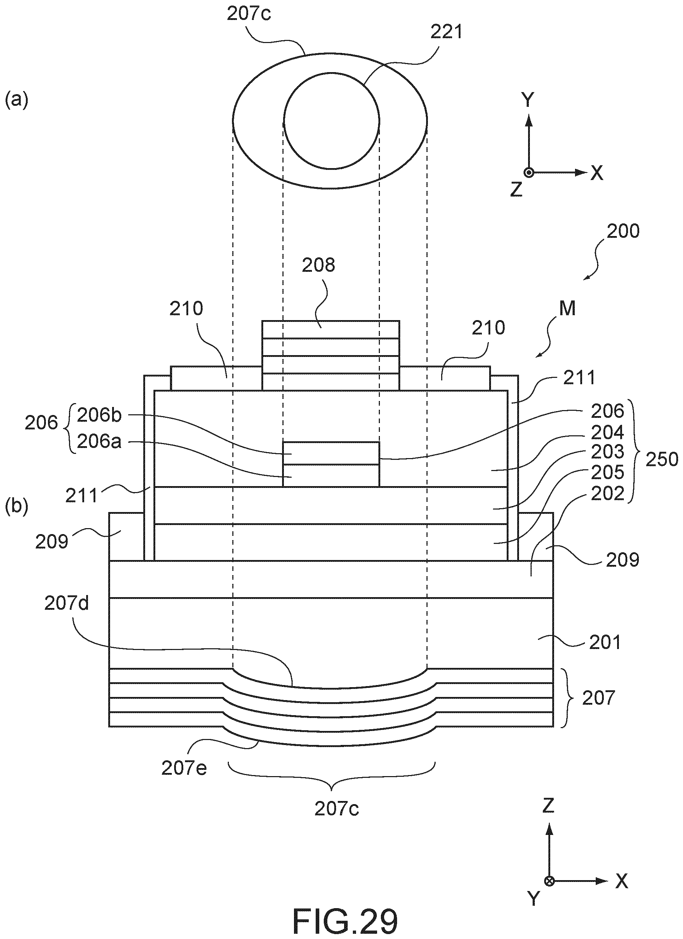

Fig. 29 is a schematic diagram showing a positional relationship between the current injection region 221 and the concave mirror 207c. Part (a) of Fig. 29 is a diagram of the current injection region 221 and the concave mirror 207c when viewed from the optical axis direction (Z direction) of laser light emitted from the VCSEL device 200, and Part (b) of Fig. 29 is a schematic cross-sectional view of the VCSEL device 200. As shown in Part (a) of Fig. 29, the concave mirror 207c is formed to include the current injection region 221 when viewed from the Z direction. Further, the concave mirror 207c is formed in a concave surface shape for collecting, in the current injection region 221, light that has entered from the side of the active layer 205.

### [Operation of VCSEL device]

The VCSEL device 200 operates similarly to the VCSEL device 100 according to the first embodiment. That is, when a voltage is applied between the first electrode 209 and the second electrode 210, a current flows between the first electrode 209 and the second electrode 210. The current is confined by the current confinement structure and injected to the current injection region 221. The spontaneous emission light caused by this injected current is reflected by the first light-reflecting layer 207 and the second light-reflecting layer 208 to cause laser oscillation. The laser light generated thereby is transmitted through the second light-reflecting layer 208 and is emitted from the VCSEL device 200 with the Z direction as the optical axis direction.

Here, in the VCSEL device 200, the concave mirror 207c is provided in the first light-reflecting layer 207. For this reason, the light that has entered the second light-reflecting layer 207 is reflected in a direction according to the shape of the concave mirror 207c and is collected in the current injection region 221. For this reason, the optical field of the laser light is controlled by the concave mirror 207c. Further, a current flowing through the VCSEL device 200 is controlled by the current injection region 221 as described above. That is, in the VCSEL device 200, an optical field and a current are controlled by separate structures.

### [Regarding plane figures of contour line of concave mirror and current injection region]

The plane figures of the contour line of the concave mirror 207c and the current injection region 221 will be described. Note that in the following description, the "plane figure" refers to the shape of the contour line and the shape of the current injection region 221 when viewed from the optical axis direction (Z direction) of laser light.

### <Regarding contour line of concave mirror>

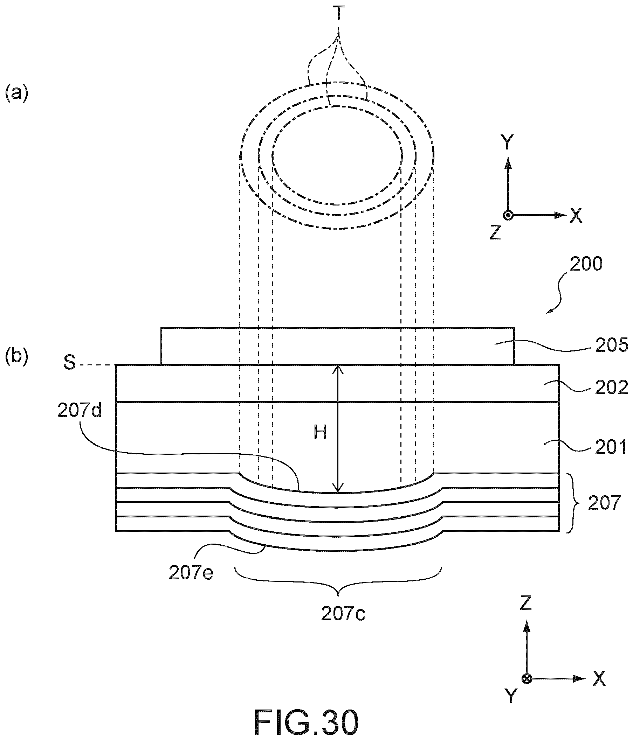

Fig. 30 is a schematic diagram showing contour lines of the concave mirror 207c. Part (a) of Fig. 30 is a plan view showing the plane figure of contour lines T of the concave mirror 207c and Part (b) of Fig. 30 is a partial schematic cross-sectional view of the VCSEL device 200. As shown in Part (b) of Fig. 30, the interface between the first semiconductor layer 202 and the active layer 205 is defined as a reference surface S. The contour line T represents a height H of the concave surface 207d from the reference surface S using a line.

### <Regarding plane figures of contour line of concave mirror and current injection region>

In the VCSEL device 200, the relationship between the plane figure of the current injection region 221 (first figure) and the plane figure of the contour line T (second figure) is similar to that in the first embodiment. That is, the plane figure of the current injection region 221 and the plane figure of the contour line T can be dissimilar (see Fig. 9 to Fig. 16). Further, the plane figure of the current injection region 221 and the plane figure of the contour line T can be similar and a non-perfect circle (see Fig. 17 to Fig. 19). Further, the center of gravity of the plane figure of the current injection region 221 and the center of gravity of the plane figure of the contour line T can be different from each other (see Fig. 20 to Fig. 23). As described in the first embodiment, with such a configuration, it is possible to improve the controllability of polarization of the VCSEL device 200.

### [Effects of VCSEL device]

Also in the VCSEL device 200, when the plane figure of the current injection region 221 and the plane figure of the contour line T have one of the relationships described above, asymmetry in the lateral direction (X-Y direction) is provided with respect to light and a current, and it is possible to improve the controllability of polarization of the VCSEL device 200.

### [Method of producing VCSEL device]

In the method of producing the VCSEL device 200, after stacking the respective layers up to the second layer 206b on the substrate 201 by a metal organic-chemical vapor deposition method or the like, unnecessary portions of the first layer 206a and the second layer 206b are removed by photolithography and etching to form the tunnel junction layer 206. The shape of the tunnel junction layer 206 can be freely controlled by photolithography.

Subsequently, the third semiconductor layer 204 is stacked on the tunnel junction layer 206, and the mesa M is formed by photolithography and etching. As a result, the stacked body 250 is formed on the substrate 201. Further, the base 201c is provided on the substrate 201 by a method similar to that in the first embodiment, and the first light-reflecting layer 207, the second light-reflecting layer 208, and the like are stacked, thereby making it possible to produce the VCSEL device 200. Further, the VCSEL device 200 can be produced by another production method.

### [Regarding current confinement structure by ion implantation]

Although a current confinement structure is provided by the buried tunnel junction by the tunnel junction layer 206 in the VCSEL device 200, as described above, a current confinement structure can also be provided by ion implantation into the tunnel junction layer 206 as escribed below.

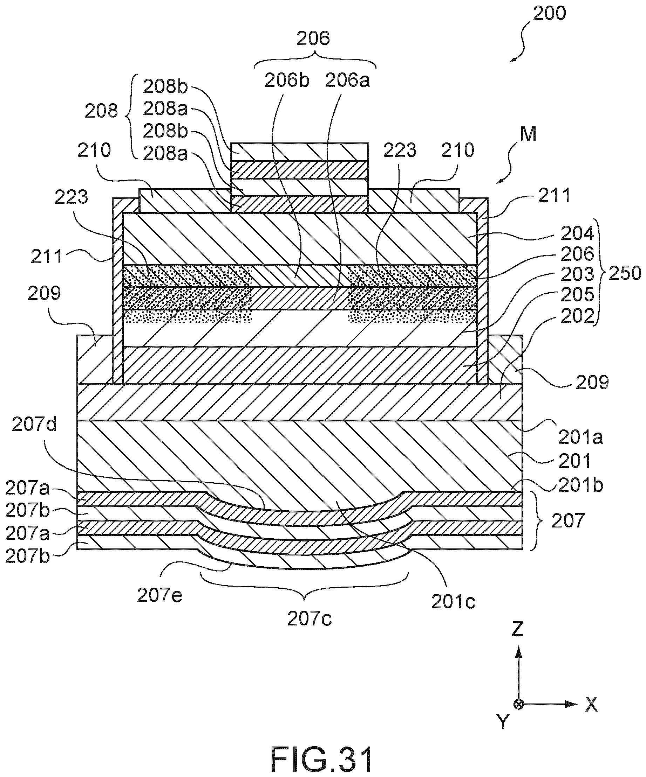

Fig. 31 is a cross-sectional view of the VCSEL device 200 having an insulation region 223 formed by ion implantation. In this configuration, the tunnel junction layer 206 is disposed entirely between the second semiconductor layer 203 and the third semiconductor layer 204, and the insulation region 223 (dotted region) is provided in the outer peripheral region of the tunnel junction layer 206.

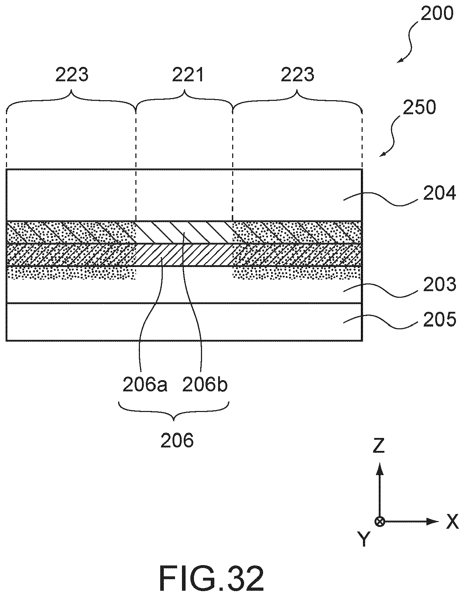

Fig. 32 is a schematic diagram showing a current confinement structure in this configuration. As shown in the figure, the current confinement structure has the current injection region 221 and the insulation region 223. The current injection region 221 is formed by the tunnel junction layer 206 into which ions are not implanted. Meanwhile, the insulation region 223 is a region that surrounds the current injection region 221 in the layer surface direction (X-Y direction) and is insulated by implanting ions into the tunnel junction layer 206. The ions to be implanted into the ion implantation region can be B (boron) ions. Further, ions capable of insulating the semiconductor material, such as O (oxygen) ions and H (hydrogen) ions, may be used instead of the B ions.

Also in this configuration, since a current flowing through the VCSEL device 200 cannot pass through the insulation region 223, the current concentrates in the current injection region 221. That is, a current confinement structure is formed by the current injection region 221 and the insulation region 223.

### [Another configuration of VCSEL device]

Although the stacked body 250 is stacked on the substrate 201 to prepare the VCSEL device 200 in the above description, the stacked body 250 may be stacked on another support substrate, and the support substrate may be removed to bond the stacked body 250 to the substrate 201. In this case, the substrate 201 can be, for example, a semi-insulating Si substrate. In this production method, when bonding the stacked body 250 and the substrate 201 to each other, the center of gravity of the plane figure of the contour line T of the concave mirror 207c and the center of gravity of the plane figure of the current injection region 221 can be made different from each other by shifting the positions of the base 201c of the substrate 201 and the tunnel junction layer 206 when viewed from the Z direction.

Further, although the interface between the first semiconductor layer 202 and the active layer 205 is defined as the reference surface S and the contour line T of the concave mirror 207c is a line representing the height of the concave surface 207d from the reference surface S in the above description, a line representing the height of the convex surface 207e from the reference surface S may be used as the contour line T. Further, the reference surface S may be the interface between the third semiconductor layer 204 and the second light-reflecting layer 208 instead of the interface between the first semiconductor layer 202 and the active layer 205.

Further, although the concave mirror 207c has been stacked on the base 201c provided on the substrate 201 to have a concave mirror shape, the present technology is not limited thereto. A structure that has a shape similar to that of the base 201c and is formed of a dielectric material, a synthetic resin, or the like may be provided on the second surface 201b (see Fig. 27) of the substrate 201, and the concave mirror 207c may be formed on the first light-reflecting layer 207 by the structure.

Further, although the first semiconductor layer 202 and the third semiconductor layer 204 have been formed of an n-type semiconductor material and the second semiconductor layer 203 has been formed of a p-type semiconductor material, the first semiconductor layer 202 and the third semiconductor layer 204 may be formed of a p-type semiconductor material and the second semiconductor layer 203 may be formed of an n-type semiconductor material. In this case, the first layer 206a of the tunnel junction layer 206 can be an n-type layer with a high impurity concentration, and the second layer 206b can be a p-type layer with a high impurity concentration. Further, the VCSEL device 200 may have another configuration capable of realizing the operation of the VCSEL device 200 described above, instead of the above-mentioned configurations.

### (Third embodiment)

A VCSEL (Vertical Cavity Surface Emitting Laser) device according to a third embodiment of the present technology will be described. The VCSEL device according to this embodiment is different from the VCSEL device according to the first embodiment mainly in the current confinement structure.

### [Structure of VCSEL device]

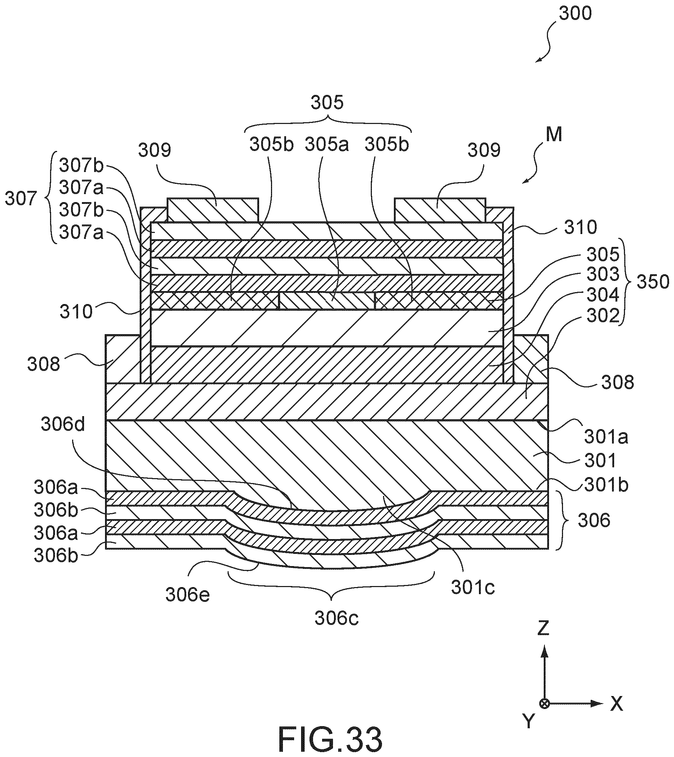

Fig. 33 is a cross-sectional view of a VCSEL device 300 according to this embodiment. As shown in the figure, the VCSEL device 300 includes a substrate 301, a first semiconductor layer 302, a second semiconductor layer 303, an active layer 304, an oxidized confinement layer 305, a first light-reflecting layer 306, a second light-reflecting layer 307, a first electrode 308, a second electrode 309, and an insulation film 310. Of these, the first semiconductor layer 302, the second semiconductor layer 303, the active layer 304, and the oxidized confinement layer 305 are collectively referred to as a stacked body 350.

Each of these layers has a layer surface direction along the X-Y plane, and the first light-reflecting layer 306, the substrate 301, the first semiconductor layer 302, the active layer 304, the second semiconductor layer 303, the oxidized confinement layer 305, and the second light-reflecting layer 307 are stacked in this order. Therefore, the stacked body 350 is disposed between the first light-reflecting layer 306 and the second light-reflecting layer 307.

The substrate 301 supports each layer of the VCSEL device 300. The substrate 301 can be, for example, a (101)-plane semi-insulating GaAs substrate. As shown in Fig. 33, the substrate 301 has a first surface 301a on the side of the active layer 304 and a second surface 301b on the side opposite to the active layer 304. A base 301c is provided on the side of the second surface 301b of the substrate 301. The base 301c is a portion of the second surface 301b that protrudes in a convex curved surface shape and has, for example, a spherical lens shape. Further, the shape of the base 301c is not limited to the spherical lens shape as long as the second surface 301b is a convex curved surface.

The first semiconductor layer 302 is a layer that is formed of a semiconductor having a first conductivity type and transports carriers to the active layer 304. The first conductivity type can be an n-type, and the first semiconductor layer 302 can be a layer formed of, for example, n-GaAs. The second semiconductor layer 303 is a layer that is formed of a semiconductor having a second conductivity type and transports carries to the active layer 304. The second conductivity type can be a p-type, and the second semiconductor layer 303 can be a layer formed of, for example, p-GaAs.

The active layer 304 is a layer that is disposed between the first semiconductor layer 302 and the second semiconductor layer 303 and emits light by carrier recombination. The active layer 304 has a multiple quantum well structure in which a quantum well layer and a barrier layer are alternately stacked to obtain a plurality of layers, the quantum well layer can be formed of, for example, GaAs, and the barrier layer can be formed of, for example, AlGaAs. Further, the active layer 304 only needs to be a layer that emits light by carrier recombination instead of the multiple quantum well structure.

The oxidized confinement layer 305 forms a current confinement structure. The oxidized confinement layer 305 has a non-oxidized region 305a in which a semiconductor material is not oxidized and an oxidized region 305b in which a semiconductor material is oxidized. The non-oxidized region 305a is formed of a material of the second conductivity type with a high impurity concentration, and can be, for example, p⁺-AlAs. The oxidized region 305b is formed of a material obtained by oxidizing the constituent material of the non-oxidized region 305a and can be, for example, an AlAs oxide.

The first light-reflecting layer 306 reflects light of a specific wavelength (hereinafter, a wavelength λ) and causes light of a wavelength other than that to be transmitted therethrough. The wavelength λ is a specific wavelength within, for example, 850 to 1400 nm. As shown in Fig. 33, the first light-reflecting layer 306 can be a DBR (Distributed Bragg Reflector) including a multilayer light-reflecting film in which a high-refractive index layer 306a and a low-refractive index layer 306b having an optical film thickness of λ/4 are alternately stacked to obtain a plurality of layers. The first light-reflecting layer 306 may be semiconductor DBR formed of a semiconductor material, or may be a dielectric DBR formed of a dielectric material.

The first light-reflecting layer 306 includes a concave mirror 306c. The first light-reflecting layer 306 is stacked on the second surface 301b of the substrate 301 to have a certain thickness, the surface thereof on the side of the stacked body 350 forms a concave surface 306d in accordance with the shape of the base 301c provided on the second surface 301b, and the surface on the side opposite to the stacked body 350 forms a convex surface 306e. As a result, the concave mirror 306c is formed in the first light-reflecting layer 306. It is suitable that in the concave mirror 306c, the radius of curvature (ROC) of the concave surface 306d is 1000 um or less and the surface accuracy (RMS: Root Mean Square) is 1 nm or less. For example, in the case where the thickness of the substrate 301 is 100 µm, the radius of curvature of the concave surface 306d can be 400 um.

The second light-reflecting layer 307 reflects light of the wavelength λ and causes light of a wavelength other than that to be transmitted therethrough. As shown in Fig. 33, the second light-reflecting layer 307 can be a DBR (Distributed Bragg Reflector) including a multilayer light-reflecting film in which a high-refractive index layer 307a and a low-refractive index layer 307b having an optical film thickness of λ/4 are alternately stacked to obtain a plurality of layers. The second light-reflecting layer 307 can be a semiconductor DBR formed of a semiconductor material.

As shown in Fig. 33, the outer periphery portions of the active layer 304, the second semiconductor layer 303, the oxidized confinement layer 305, and the second light-reflecting layer 307 are removed to form a mesa (plateau structure) M.

The first electrode 308 is provided around the mesa M on the first semiconductor layer 302 and functions as one electrode of the VCSEL device 300. The first electrode 308 can include, for example, a single-layer metal film formed of Au, Ni, Ti, or the like, or a multiplayer metal film formed of Ti/Au, Ag/Pd, Ni/Au/Pt, or the like.

The second electrode 309 is provided on the second light-reflecting layer 307 and functions as the other electrode of the VCSEL device 300. The second electrode 309 can include, for example, a single-layer metal film formed of Au, Ni, Ti, or the like, or a multiplayer metal film formed of Ti/Au, Ag/Pd, Ni/Au/Pt, or the like. The insulation film 310 is provided around the second electrode 309 on the side surface of the mesa M and the upper surface of the mesa M to insulate the outer periphery of the mesa M. The insulation film 310 is formed of an arbitrary insulating material.

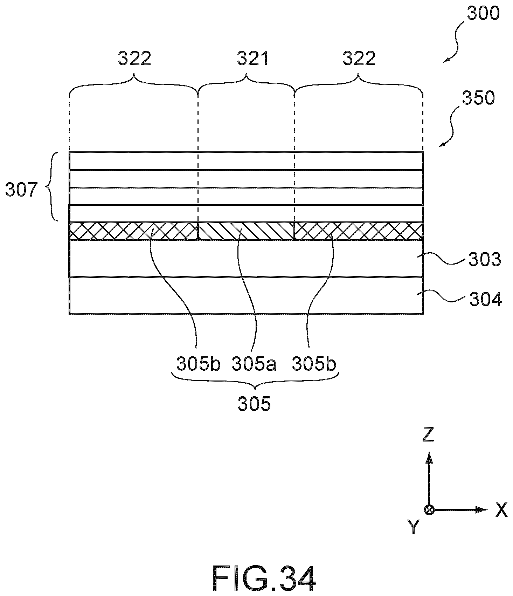

In the VCSEL device 300, a current confinement structure is formed in the stacked body 350 by the oxidized confinement layer 305. Fig. 34 is a schematic diagram showing a current confinement structure. As shown in the figure, the current confinement structure has a current injection region 321 and an insulation region 322. The current injection region 321 is a region having conductivity by the non-oxidized region 305a. The insulation region 322 is a region that surrounds the current injection region 221 in the layer surface direction (X-Y direction) and has no conductivity by the oxidized region 305b insulated by oxidation. Since a current flowing through the VCSEL device 300 cannot pass through the insulation region 322, the current concentrates in the current injection region 321. That is, in the VCSEL device 300, a current confinement structure is formed by the oxidized confinement layer 305.

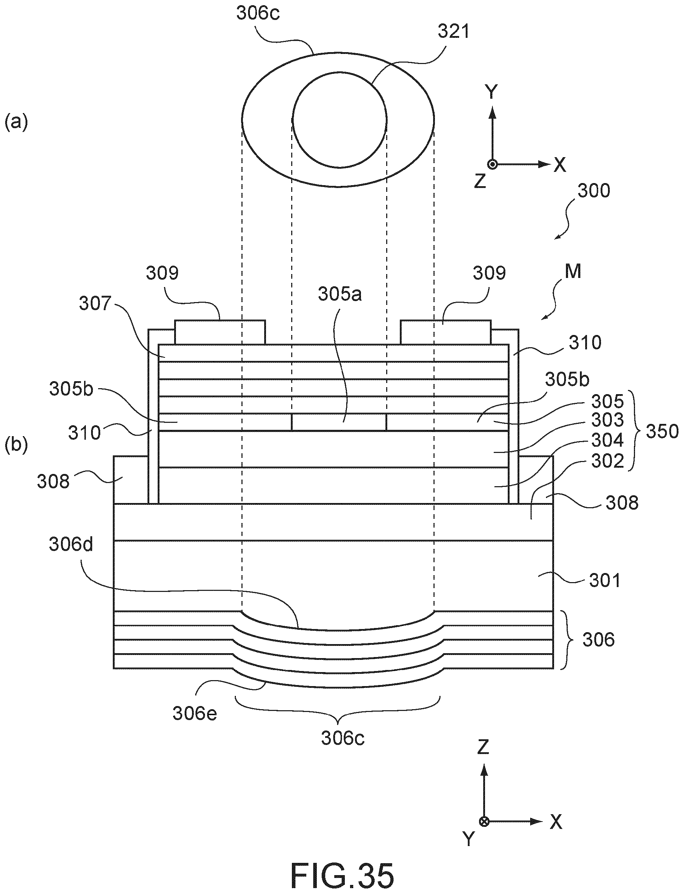

Fig. 35 is a schematic diagram showing a positional relationship between the current injection region 321 and the concave mirror 306c. Part (a) of Fig. 35 is a diagram of the current injection region 321 and the concave mirror 306c when viewed from the optical axis direction (Z direction) of laser light emitted from the VCSEL device 300, an Part (b) of Fig. 35 is a schematic cross-sectional view of the VCSEL device 300. As shown in Part (a) of Fig. 35, the concave mirror 306c is formed to include the current injection region 321 when viewed from the Z direction. Further, the concave mirror 306c is formed in a concave surface shape for collecting, in the current injection region 321, light that has entered from the side of the active layer 304.

### [Operation of VCSEL device]

The VCSEL device 300 operates similarly to the VCSEL device 300 according to the first embodiment. That is, when a voltage is applied between the first electrode 308 and the second electrode 309, a current flows between the first electrode 308 and the second electrode 309. The current is confined by the current confinement structure and injected to the current injection region 321. The spontaneous emission light generated by this injected current is reflected by the first light-reflecting layer 306 and the second light-reflecting layer 307 to cause laser oscillation. The laser light generated thereby is transmitted through the second light-reflecting layer 307 and is emitted from the VCSEL device 300 with the Z direction as the optical axis direction.

Here, in the VCSEL device 300, the concave mirror 306c is provided in the first light-reflecting layer 306. For this reason, the light that has entered the second light-reflecting layer 306 is reflected in a direction according to the shape of the concave mirror 306c and is collected in the current injection region 321. For this reason, the optical field of the laser light is controlled by the concave mirror 306c. Further, a current flowing through the VCSEL device 300 is controlled by the current injection region 321 as described above. That is, in the VCSEL device 300, an optical field and a current are controlled by separate structures.

### [Regarding plane figures of contour line of concave mirror and current injection region]

The plane figures of the contour line of the concave mirror 306c and the current injection region 321 will be described. Note that in the following description, the "plane figure" refers to the shape of the contour line and the shape of the current injection region 321 when viewed from the optical axis direction (Z direction) of the laser light.

### <Regarding contour line of concave mirror>

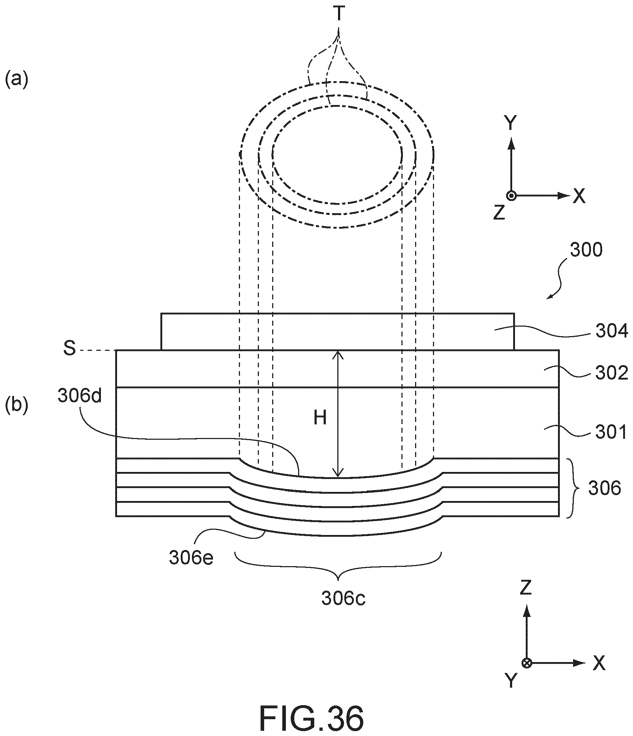

Fig. 36 is a schematic diagram showing contour lines of the concave mirror 306c. Part (a) of Fig. 36 is a plan view showing the plane figure of contour lines T of the concave mirror 306c, and Part (b) of Fig. 36 is a partial schematic cross-sectional view of the VCSEL device 300. As shown in Part (b) of Fig. 36, the interface between the first semiconductor layer 302 and the active layer 304 is defined as a reference surface S. The contour line T represents a height H of the concave surface 306d from the reference surface S using a line.

### <Regarding plane figures of contour line of concave mirror and current injection region>

In the VCSEL device 300, the relationship between the plane figure of the current injection region 321 (first figure) and the plane figure of the contour line T (second figure) is similar to that in the first embodiment. That is, the plane figure of the current injection region 321 and the plane figure of the contour line T can be dissimilar (see Fig. 9 to Fig. 16). Further, the plane figure of the current injection region 321 and the plane figure of the contour line T can be similar and a non-perfect circle (see Fig. 17 to Fig. 19). Further, the center of gravity of the plane figure of the current injection region 321 and the center of gravity of the plane figure of the contour line T can be different from each other (see Fig. 20 to Fig. 23). As described in the first embodiment, it is possible to improve the controllability of polarization of the VCSEL device 300 with such a configuration.

### [Effects of VCSEL device]

Also in the VCSEL device 300, when the plane figure of the current injection region 321 and the plane figure of the contour line T have one of the relationships described above, asymmetry in the lateral direction (X-Y direction) is provided with respect to light and a current, and it is possible to improve the controllability of polarization of the VCSEL device 300.

### [Method of producing VCSEL device]

In the method of producing the VCSEL device 300, after stacking the respective layers up to the second light-reflecting layer 307 on the substrate 301 by a metal organic-chemical vapor deposition method or the like, the mesa M is formed by photolithography and etching. Subsequently, the oxidized region 305b is formed by oxidizing the material of the oxidized confinement layer 305 from the side of the outer periphery by a method such as heating the stacked body 350 under a water vapor atmosphere. At this time, the shape of the non-oxidized region 305a when viewed from the Z direction can be controlled by the shape of the mesa M when viewed from the Z direction.

Further, the base 301c is provided on the substrate 301 by a method similar to that in the first embodiment, and the first light-reflecting layer 306, the second light-reflecting layer 307, and the like are stacked, thereby making it possible to produce the VCSEL device 300. Further, the VCSEL device 300 can be produced by another production method.

### [Another configuration of VCSEL device]

Although the stacked body 350 is stacked on the substrate 301 to prepare the VCSEL device 300 in the above description, the stacked body 350 may be stacked on another support substrate, and the support substrate may be removed to bond the stacked body 350 to the substrate 301. In this case, the substrate 301 can be, for example, a semi-insulating Si substrate. In this production method, when bonding the stacked body 350 and the substrate 301 to each other, the center of gravity of the plane figure of the contour line T of the concave mirror 306c and the center of gravity of the plane figure of the current injection region 321 can be made different from each other by shifting the positions of the base 301c of the substrate 301 and the non-oxidized region 305a when viewed from the Z direction.

Further, although the interface between the first semiconductor layer 302 and the active layer 304 is defined as the reference surface S and the contour line T of the concave mirror 306c is a line representing the height of the concave surface 306d from the reference surface S in the above description, a line representing the height of the convex surface 306e from the reference surface S may be used as the contour line T. Further, the reference surface S may be the interface between the second semiconductor layer 303 and the second light-reflecting layer 307 instead of the interface between the first semiconductor layer 302 and the active layer 304.

Further, although the concave mirror 306c has been stacked on the base 301c provided on the substrate 301 to have a concave mirror shape, the present technology is not limited thereto. A structure that has a shape similar to that of the base 301c and is formed of a dielectric material, a synthetic resin, or the like may be provided on the second surface 301b (see Fig. 33) of the substrate 301, and the concave mirror 306c may be formed on the first light-reflecting layer 306 by the structure.

Further, although the first semiconductor layer 302 has been formed of an n-type semiconductor material and the second semiconductor layer 303 has been formed of a p-type semiconductor material, the first semiconductor layer 302 may be formed of a p-type semiconductor material and the second semiconductor layer 303 may be formed of an n-type semiconductor material. In this case, the non-oxidized region 305a of the oxidized confinement layer 305 can be formed of an n-type material with a high impurity concentration. Further, the VCSEL device 300 may have another configuration capable of realizing the operation of the VCSEL device 300 described above, instead of the above-mentioned configurations.

### (Regarding present disclosure)

The effects described in the present disclosure are merely examples and are not limited, and additional effects may be exerted. The description of the plurality of effects described above does not necessarily mean that these effects are exhibited simultaneously. It means that at least one of the effects described above can be achieved in accordance with the conditions or the like, and there is a possibility that an effect that is not described in the present disclosure is exerted. Further, at least two feature portions of the feature portions described in the present disclosure may be arbitrarily combined with each other.

It should be noted that the present technology may also take the following configurations.
(1) A vertical cavity surface emitting laser device, including:
   a first light-reflecting layer that reflects light of a specific wavelength;
   a second light-reflecting layer that reflects light of the wavelength; and
   a stacked body that includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination,
   the stacked body having a current confinement structure for confining a current and forming a current injection region where a current concentrates,
   the first light-reflecting layer including a concave mirror having a concave surface on a side of the stacked body and a convex surface on a side opposite to the stacked body,
   a first figure and a second figure being not similar, the first figure being a plane figure of the current injection region when viewed from an optical axis direction of emitted light, the second figure being a plane figure of a contour line when viewed from the optical axis direction, the contour line representing a height of the concave mirror from the active layer.
(2) A vertical cavity surface emitting laser device, including:
   a first light-reflecting layer that reflects light of a specific wavelength;
   a second light-reflecting layer that reflects light of the wavelength; and
   a stacked body that includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination,
   the stacked body having a current confinement structure for confining a current and forming a current injection region where a current concentrates,
   the first light-reflecting layer including a concave mirror having a concave surface on a side of the stacked body and a convex surface on a side opposite to the stacked body,
   a center of gravity of a first figure and a center of gravity of a second figure not matching, the first figure being a plane figure of the current injection region when viewed from an optical axis direction of emitted light, the second figure being a plane figure of a contour line when viewed from the optical axis direction, the contour line representing a height of the concave mirror from the active layer.
(3) A vertical cavity surface emitting laser device, including:
   a first light-reflecting layer that reflects light of a specific wavelength;
   a second light-reflecting layer that reflects light of the wavelength; and
   a stacked body that includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination,
   the stacked body having a current confinement structure for confining a current and forming a current injection region where a current concentrates,
   the first light-reflecting layer including a concave mirror having a concave surface on a side of the stacked body and a convex surface on a side opposite to the stacked body,
   both a first figure and a second figure being not perfect circles but similar, the first figure being a plane figure of the current injection region when viewed from an optical axis direction of emitted light, the second figure being a plane figure of a contour line when viewed from the optical axis direction, the contour line representing a height of the concave mirror from the active layer.
(4) The vertical cavity surface emitting laser device according to (1) above, in which
   the first figure is a closed figure including a circle, an ellipse, a rectangle, or a combination of at least two of them, and
   the second figure is a closed figure including a circle, an ellipse, a rectangle, or a combination of at least two of them and is a figure dissimilar to the first figure.
(5) The vertical cavity surface emitting laser device according to (2) above, in which
   a distance between the center of gravity of the first figure and the center of gravity of the second figure in a plane perpendicular to the optical axis direction is 0.03 um or more.
(6) The vertical cavity surface emitting laser device according to (3) above, in which
   the first figure is a closed figure including a circle, an ellipse, a rectangle, or a combination of at least two of them, and
   the second figure is a closed figure including a circle, an ellipse, a rectangle, or a combination of at least two of them and is a figure similar to the first figure.
(7) The vertical cavity surface emitting laser device according to (1) or (3) above, in which
   the center of gravity of the first figure and the center of gravity of the second figure match.
(8) The vertical cavity surface emitting laser device according to any one of (1) to (7) above, in which
   the current confinement structure has a non-ion-implantation region in which ions are not implanted into the stacked body and an ion implantation region that is provided around the non-ion-implantation region, ions being implanted into the stacked body in the ion implantation region, the current injection region being the non-ion-implantation region.
(9) The vertical cavity surface emitting laser device according to (8) above, in which
   the first semiconductor layer and the second semiconductor layer are formed of GaN.
(10) The vertical cavity surface emitting laser device according to (9) above, in which
   the first semiconductor layer includes a C-plane GaN substrate.
(11) The vertical cavity surface emitting laser device according to any one of (8) to (10) above, in which
   the ions are boron ions.
(12) The vertical cavity surface emitting laser device according to any one of (1) to (7) above, in which
   the current confinement structure has a tunnel junction region in which a tunnel junction is formed in the stacked body and a non-tunnel-junction region that is provided around the tunnel junction region, no tunnel junction being formed in the non-tunnel-junction region, and
   the current injection region is the tunnel junction region.
(13) The vertical cavity surface emitting laser device according to (12) above, in which
   the tunnel junction region is formed by a buried tunnel junction.
(14) The vertical cavity surface emitting laser device according to (12) above, in which
   the tunnel junction region is formed by a tunnel junction layer into which ions are not implanted, and
   the non-tunnel-junction region is formed by a tunnel junction layer into which ions are implanted.
(15) The vertical cavity surface emitting laser device according to any one of (12) to (14) above, in which
   the first semiconductor layer and the second semiconductor layer are formed of InP.
(16) The vertical cavity surface emitting laser device according to any one of (1) to (7) above, in which
   the current confinement structure has a non-oxidized region in which a semiconductor material is not oxidized in the stacked body and an oxidized region that is provided around the non-oxidized region, a semiconductor material being oxidized in the oxidized region,
   the current injection region is the non-oxidized region.
(17) The vertical cavity surface emitting laser device according to (16) above, in which
   the first semiconductor layer and the second semiconductor layer are formed of GaAs.
(18) The vertical cavity surface emitting laser device according to any one of (1) to (17) above, in which
   the first semiconductor layer has a first surface on a side of the active layer and a second surface on a side opposite to the active layer, a base that forms a convex curved surface being provided on the second surface, and
   the first light-reflecting layer is a multilayer light-reflecting film provided on the second surface, a portion of the first light-reflecting layer that is a multilayer light-reflecting film forming and provided on the base forming the concave mirror.
(19) The vertical cavity surface emitting laser device according to any one of (1) to (17) above, further including
   a substrate that has a first surface on a side of the active layer and a second surface on a side opposite to the active layer, a base that forms a convex curved surface being provided on the second surface,
   the first light-reflecting layer being a multilayer light-reflecting film provided on the second surface, a portion of the first light-reflecting layer that is a multilayer light-reflecting film and provided on the base forming the concave mirror.
(20) The vertical cavity surface emitting laser device according to any one of (1) to (19) above, in which
   the concave mirror has a concave surface on a side of the active layer, and the concave surface has a radius of curvature of 1000 um or less.

### Reference Signs List

100, 200, 300 VCSEL device
201, 301 substrate
101, 202, 302 first semiconductor layer
102, 203, 303 second semiconductor layer
204 third semiconductor layer
103, 205, 304 active layer
206 tunnel junction layer
305 oxidized confinement layer
104, 207, 306 first light-reflecting layer
104c, 207c, 306c concave mirror
105, 208, 307 second light-reflecting layer
106, 209, 308 first electrode
107, 210, 309 second electrode
121, 221, 321 current injection region
122, 222, 322 insulation region
150, 250, 350 stacked body

## Claims

1. A vertical cavity surface emitting laser device, comprising:
a first light-reflecting layer that reflects light of a specific wavelength;
a second light-reflecting layer that reflects light of the wavelength; and
a stacked body that includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination,
the stacked body having a current confinement structure for confining a current and forming a current injection region where a current concentrates,
the first light-reflecting layer including a concave mirror having a concave surface on a side of the stacked body and a convex surface on a side opposite to the stacked body,
a first figure and a second figure being not similar, the first figure being a plane figure of the current injection region when viewed from an optical axis direction of emitted light, the second figure being a plane figure of a contour line when viewed from the optical axis direction, the contour line representing a height of the concave mirror from the active layer.

2. A vertical cavity surface emitting laser device, comprising:
a first light-reflecting layer that reflects light of a specific wavelength;
a second light-reflecting layer that reflects light of the wavelength; and
a stacked body that includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination,
the stacked body having a current confinement structure for confining a current and forming a current injection region where a current concentrates,
the first light-reflecting layer including a concave mirror having a concave surface on a side of the stacked body and a convex surface on a side opposite to the stacked body,
a center of gravity of a first figure and a center of gravity of a second figure not matching, the first figure being a plane figure of the current injection region when viewed from an optical axis direction of emitted light, the second figure being a plane figure of a contour line when viewed from the optical axis direction, the contour line representing a height of the concave mirror from the active layer.

3. A vertical cavity surface emitting laser device, comprising:
a first light-reflecting layer that reflects light of a specific wavelength;
a second light-reflecting layer that reflects light of the wavelength; and
a stacked body that includes a first semiconductor layer, a second semiconductor layer, and an active layer, and is disposed between the first light-reflecting layer and the second light-reflecting layer, the first semiconductor layer being formed of a semiconductor material having a first conductivity type, the second semiconductor layer being formed of a semiconductor material having a second conductivity type, the active layer being disposed between the first semiconductor layer and the second semiconductor layer and emitting light by carrier recombination,
the stacked body having a current confinement structure for confining a current and forming a current injection region where a current concentrates,
the first light-reflecting layer including a concave mirror having a concave surface on a side of the stacked body and a convex surface on a side opposite to the stacked body,
both a first figure and a second figure being not perfect circles but similar, the first figure being a plane figure of the current injection region when viewed from an optical axis direction of emitted light, the second figure being a plane figure of a contour line when viewed from the optical axis direction, the contour line representing a height of the concave mirror from the active layer.

4. The vertical cavity surface emitting laser device according to claim 1, wherein
the first figure is a closed figure including a circle, an ellipse, a rectangle, or a combination of at least two of them, and
the second figure is a closed figure including a circle, an ellipse, a rectangle, or a combination of at least two of them and is a figure dissimilar to the first figure.

5. The vertical cavity surface emitting laser device according to claim 2, wherein
a distance between the center of gravity of the first figure and the center of gravity of the second figure in a plane perpendicular to the optical axis direction is 0.03 um or more.

6. The vertical cavity surface emitting laser device according to claim 3, wherein
the first figure is a closed figure including a circle, an ellipse, a rectangle, or a combination of at least two of them, and
the second figure is a closed figure including a circle, an ellipse, a rectangle, or a combination of at least two of them and is a figure similar to the first figure.

7. The vertical cavity surface emitting laser device according to claim 1 or 3, wherein
the center of gravity of the first figure and the center of gravity of the second figure match.

8. The vertical cavity surface emitting laser device according to any one of claims 1 to 3, wherein
the current confinement structure has a non-ion-implantation region in which ions are not implanted into the stacked body and an ion implantation region that is provided around the non-ion-implantation region, ions being implanted into the stacked body in the ion implantation region, the current injection region being the non-ion-implantation region.

9. The vertical cavity surface emitting laser device according to claim 8, wherein
the first semiconductor layer and the second semiconductor layer are formed of GaN.

10. The vertical cavity surface emitting laser device according to claim 9, wherein
the first semiconductor layer includes a C-plane GaN substrate.

11. The vertical cavity surface emitting laser device according to claim 8, wherein
the ions are boron ions.

12. The vertical cavity surface emitting laser device according to any one of claims 1 to 3, wherein
the current confinement structure has a tunnel junction region in which a tunnel junction is formed in the stacked body and a non-tunnel-junction region that is provided around the tunnel junction region, no tunnel junction being formed in the non-tunnel-junction region, and
the current injection region is the tunnel junction region.

13. The vertical cavity surface emitting laser device according to claim 12, wherein
the tunnel junction region is formed by a buried tunnel junction.

14. The vertical cavity surface emitting laser device according to claim 12, wherein
the tunnel junction region is formed by a tunnel junction layer into which ions are not implanted, and
the non-tunnel-junction region is formed by a tunnel junction layer into which ions are implanted.

15. The vertical cavity surface emitting laser device according to claim 12, wherein
the first semiconductor layer and the second semiconductor layer are formed of InP.

16. The vertical cavity surface emitting laser device according to any one of claims 1 to 3, wherein
the current confinement structure has a non-oxidized region in which a semiconductor material is not oxidized in the stacked body and an oxidized region that is provided around the non-oxidized region, a semiconductor material being oxidized in the oxidized region,
the current injection region is the non-oxidized region.

17. The vertical cavity surface emitting laser device according to claim 16, wherein
the first semiconductor layer and the second semiconductor layer are formed of GaAs.

18. The vertical cavity surface emitting laser device according to any one of claims 1 to 3, wherein
the first semiconductor layer has a first surface on a side of the active layer and a second surface on a side opposite to the active layer, a base that forms a convex curved surface being provided on the second surface, and
the first light-reflecting layer is a multilayer light-reflecting film provided on the second surface, a portion of the first light-reflecting layer that is a multilayer light-reflecting film forming and provided on the base forming the concave mirror.

19. The vertical cavity surface emitting laser device according to any one of claims 1 to 3, further comprising
a substrate that has a first surface on a side of the active layer and a second surface on a side opposite to the active layer, a base that forms a convex curved surface being provided on the second surface,
the first light-reflecting layer being a multilayer light-reflecting film provided on the second surface, a portion of the first light-reflecting layer that is a multilayer light-reflecting film and provided on the base forming the concave mirror.

20. The vertical cavity surface emitting laser device according to any one of claims 1 to 3, wherein
the concave mirror has a concave surface on a side of the active layer, and the concave surface has a radius of curvature of 1000 um or less.
